# EUROPEAN PATENT SPECIFICATION

(11) **EP 3 029 724 B1**
(45) Date of publication and mention of the grant of the patent: **07.06.2017**
(21) Application number: 15183574.1
(22) Date of filing: 02.09.2015
(51) Int. Cl.: H01L 21/768

(54) **METALLIZATION METHOD FOR SEMICONDUCTOR STRUCTURES**
METALLISIERUNGSVERFAHREN FÜR HALBLEITERSTRUKTUREN
PROCÉDÉ DE MÉTALLISATION DE STRUCTURES À SEMI-CONDUCTEURS

(30) Priority: 01.12.2014 EP 14195695
(43) Date of publication of application: 08.06.2016
(73) Proprietor: IMEC VZW, 3001 Leuven (BE)
(72) Inventor: Chan, Boon Teik, 3001 Leuven (BE); Armini, Silvia, 3001 Leuven (BE); Lazzarino, Frederic, 3001 Leuven (BE)
(74) Representative: Ego, Christophe

(56) References cited:
- EP-A1- 1 670 054
- WO-A1-01/56078
- US-A1- 2002 058 405
- US-A1- 2006 063 370
- US-A1- 2014 273 434

## Description

### Technical field of the invention

The present invention relates to the field of semiconductor fabrication methods and more in particular to the field of metallization methods.

### Background of the invention

US 2006/063370 A1 discloses a method for fabricating integrated circuit structures for use in semiconductor wafer fabrication techniques. The method comprises providing a structure comprising a first sacrificial layer comprising a first through hole exposing a sensitizer layer, depositing a metal layer selectively on the exposed sensitizer layer using electroless deposition, depositing selectively, using electroless Cu deposition, a second metal layer in the first through hole, thereby forming a first Cu plug, depositing a second sacrificial layer on the first sacrificial layer and the first Cu plug, forming a second Cu plug in the second sacrificial layer on the first Cu plug, using a selective electroless Cu deposition technique similar to the technique that is employed for fabricating first Cu plug, fabricating a via in the second sacrificial layer, removing the first and second sacrificial layers, and depositing a dielectric material to replace the removed sacrificial layers.

US 2014/273434 A1 discloses a method of fabricating a semiconductor device including forming a non-conductive layer over a semiconductor substrate. A low-k dielectric layer is formed over the non-conductive layer. The low-k dielectric layer is etched and stopped at the non-conductive layer to form an opening. A plasma treatment is performed on the substrate to convert the non-conductive layer within the opening into a conductive layer. Self-assembled Monolayers (SAMs) are deposited in the opening as nucleation layers for seed layer deposition. The opening is filled with a copper-containing material in an electroless copper bottom up fill process to form a copper-containing plug. The non-conductive layers are metal nitrides or oxynitrides or aluminium oxide.

U.S. Pat. N° 8,652,962 discloses a method for forming a dual damascene metal interconnect for a semiconductor device. The method comprises providing a semiconductor substrate, forming gate structures on the substrate through front end of line processing, forming a dielectric layer over the gate structures, patterning vias through the dielectric layer, forming a sacrificial layer over the low-k dielectric layer, patterning trenches through the sacrificial layer, filling the vias and trenches with metal, removing the sacrificial layer by mean of a Chemical Mechanical Planarization (CMP) process, and forming an extremely low-k dielectric layer over the dielectric layer. This method aims at introducing low dielectric constant layers into semiconductor devices while avoiding damages to the extremely low-k dielectric. The present inventors however realized that this method still introduce significant damages in the structures as it does not avoid defects formation in the metal structures, in the dielectric in which the vias are formed and in the barrier lining the vias and trenches. There is therefore still a need for methods not suffering from these drawbacks.

### Summary of the invention

It is an object of the present invention to provide good methods for the metallization of semiconductor structures.

It is an advantage of embodiments of the present invention that the damages caused during the metallization process can be low.

It is an advantage of embodiments of the present invention that they lead to a low defect level in the metal structures obtained upon filling vias and trenches. This advantage is achieved in embodiments by the combined use of strategically placed selective self-assembled monolayers (SAMs) and of sacrificial layers. The present inventors observed that this combined use permitted an excellent bottom up filling of the vias and trenches, thereby avoiding defects observed when the filling of the vias or trenches proceeds at least in part from the side-walls of the vias and trenches. When the filling proceeds at least in part from the side walls, defects are unavoidable at the junction of the growth fronts stemming from opposite side walls. Other frequent defects observed when the filling proceeds at least in part from the side walls is the presences of voids in the vias and/or trenches due to an upper part of the via/trench being filled before that a lower part had the time to be filled. This is particularly advantageous in the case of the 7nm node technology or beyond where trenches and/or vias of lateral dimension equal or inferior to 7 nm must be metallized.

The bottom-up filling has the further advantage that the vertical progression of the metallization can be better controlled by interrupting the growing of the metal when the top front of the growing metal reaches the top of the sacrificial layer(s) in which the via and/or trench was etched. This permits to avoid or to minimize the use of the expensive CMP.

It is an advantage of embodiments of the present invention that by making use of a sacrificial layer for etching the vias and/or trenches, and by replacing it with a replacement dielectric layer (which can be a low-k layer) after metallization, the process is damage-free for the dielectric, even if plasma etching is used.

The above objective is accomplished by a method and device according to the present invention.

In a first aspect, the present invention relates to a method for fabricating a semiconductor device, comprising:
a. Providing a structure comprising a first sacrificial layer comprising at least one through-hole exposing an underlying metal surface and optionally an underlying oxide surface,
b. Applying a self-assembled monolayer selectively on the exposed metal surface and/or on the oxide surface,
c. Growing a metal
   i. on the self-assembled monolayer, and
   ii. on the exposed metal surface if no self-assembled monolayer is present thereon,
      so as to fill the at least one through-hole, thereby forming at least one metal structure,
d. Replacing the first sacrificial layer by a replacement dielectric layer having a dielectric constant of at most 3.9.

In embodiments, step b may comprise applying a self-assembled monolayer selectively
i. on the exposed metal surface, if no underlying oxide surface is exposed by the trough-hole, or
ii. only on the exposed oxide surface if present,

When an oxide surface is exposed, applying a self-assembled monolayer selectively thereon is advantageous because it permits to bring the metal growth rate on the metal surface and the oxide surface closer to one another, thereby avoiding the creation of defects due to very different growth rates.

Preferably, the lateral dimensions of the underlying metal surface correspond to the lateral dimensions of the through-hole and the underlying metal surface is aligned with the through-hole.

Typically, the underlying metal surface may belong to a metal plug such as e.g. a tungsten plug.

Typically, the underlying oxide surface may be a SiO₂ surface.

In embodiments, where the through-holes are vias, there may be at least as many underlying metal surfaces as vias, and each via may be aligned with an underlying metal surfaces.

In embodiments, where the trough-holes are trenches, there may be more underlying metal surfaces than trenches, and each trench may be aligned with one or more underlying metal surface.

Typically, if no underlying oxide is exposed by the through-holes, the through-holes are vias. Typically, when the through-holes are vias, the SAM is only applied on the exposed underlying metal surfaces.

Typically, if both a metal surface and an underlying oxide surface are exposed by the through-holes, the through-holes are trenches and the exposed underlying oxide surface is a portion of the underlying oxide surface aligned with the trench. Typically, when the through-holes are trenches, the SAM is only present on the exposed underlying oxide surfaces.

As used herein and unless provided otherwise, the SAMs are such as to promote the growth of the metal of step c. They are also such as to attach selectively to the relevant underlying surface. For instance, SAMs suitable for attaching selectively to the underlying metal surface may comprise an organic compound of formula B-R-A, wherein A is selected from SH, SeH, TeH, wherein R is a hydrocarbyl comprising from 2 to 20 carbon atoms, and wherein B is a polar group suitable for promoting metal growth.

For instance, SAMs suitable for attaching selectively to the underlying oxide surface may comprise an organic compound of formula B-R-SiX₃, wherein X is selected from H, Cl, O-CH₃, O-C₂H₅, and O-C₃H₇, wherein R is a hydrocarbyl comprising from 2 to 20 carbon atoms, and wherein B is a polar group suitable for promoting metal growth.

Example of such polar groups are primary and secondary amine groups, mercapto groups, and carboxylic groups. By applying the SAM selectively on the exposed metal surface, if no underlying oxide surface is exposed by the trough-hole, or on the oxide surface if present, no SAM is present on the side walls of the through-holes. This is advantageous as it promotes a bottom-up growth of the metal and prevents metal growth from the side-walls which causes defects at the junction of the growth fronts stemming from opposite side walls or causes the presence of voids in the vias and/or trenches due to an upper part of the via/trench being filled before that a lower part had the time to be filled.

The "underlying" layer is a layer lying under the sacrificial layer.

As used herein and unless provided otherwise, the (first, second and third) sacrificial layers may be formed of a material that decomposes and/or vaporizes by thermal treatment at a temperature between 250 and 450°C, by UV treatment or by a combination of those treatments. Preferably, the sacrificial layer is an organic sacrificial layer. The inventors observed that organic sacrificial layers form walls on which metal growth is not promoted, thereby favouring bottom-up metal growth. Furthermore, organic sacrificial layers can be removed easily. For instance, the organic sacrificial layers can be removed by means of a dry strip process such as plasma stripping. A dry strip process permits to avoid pattern collapse. Non-organic trench walls such as oxide walls typically require a wet etching which tend to lead to pattern collapse during developing and/or rinsing due to capillary force. The organic sacrificial layers may for instance be deposited by spin-coating or plasma enhanced chemical vapour deposition (PECVD). Typical examples include spin-on-carbon (SOC) and advanced patterning film (APF). APF is deposited by PECVD. Further examples are organic polymers such as polymethyl methacrylate, polyimide, polypropylene glycol, polybutadiene, polyethylene glycol, and polycaprolactonediol, amongst others.

In embodiments, the metal grown in step c may be any metal suitable for forming an interconnect or a conducting line. Examples are Cu, Co, Ni, and Ru.

In embodiments, the replacement dielectric layer may be a low-k dielectric layer, i.e. a layer having a dielectric constant lower than 3.9 and preferably lower than 2.4. Examples of low-k dielectric materials are silicate glasses such as carbon-doped silicon dioxide and fluorine-doped silicon dioxide. In order to have a lower dielectric constant, the replacement dielectric layer may be porous. For instance it may have a porosity of at least 20%.

In embodiments where the at least one through-holes is at least one via, the method may comprise:
a. Providing a structure comprising a first sacrificial layer comprising at least one via exposing a metal surface,
b. Applying a self-assembled monolayer selectively on the exposed metal surface,
c. Growing a metal on the self-assembled monolayer so as to fill the at least one via, thereby forming at least one metal pillar,
d. Replacing the first sacrificial layer by a replacement dielectric layer having a dielectric constant of at most 3.9.

In the previous embodiment, if both at least one via and at least one trench are wished, the structure may further comprise a first dielectric layer overlaying the first sacrificial layer, and a second sacrificial layer overlaying the first dielectric layer, and the method may further comprise after step a and before step b:
i. Covering the side walls of the via with a passivation layer such as a hydrophilic layer (e.g. a hydrophilic polymer),
ii. Filling the at least one via with a dielectric material so that the top surface of the dielectric material and the top surface of the second sacrificial layer are coplanar,
iii. Overlaying the dielectric material and the second sacrificial layer with a hard mask,
iv. Overlaying the hard mask with a third sacrificial layer,
v. Overlaying the third sacrificial layer with a second dielectric layer,
vi. Etching one or more trenches through the second dielectric layer, the third sacrificial layer, and the hard mask so that at least one of said trenches is aligned with at least one via, thereby exposing the dielectric material and part of the second sacrificial layer, and
vii. Removing the dielectric material, thereby exposing the metal surface.

This is advantageous as it permits to have both the vias and the trenches formed in sacrificial layers. This permits the replacement of the sacrificial layers by a replacement dielectric layer having a dielectric constant of at most 3.9. This replacement layer will surround both the vias and the trenches and have a low amount of defects since it will not have suffered etching-induced damages. An advantage of this embodiment is that it enables a dual damascene process, i.e. a process where both the via and the trenches are formed prior to their filling with a metal. Such a process has the advantage that a single CMP is sufficient after metallization. CMP is a very expensive step. Furthermore, by etching the via through two sacrificial layers, controlling uniformity of the layers is easier than in the alternative option (see fifth mode of realization) where uniformity must be maintained during partial etching of the first sacrificial layer (the step leading to a top portion of the at least one dielectric pillar to stand out of the first sacrificial layer). Also, the absence of the standing out pillar makes uniformity control easier.

As used herein and unless provided otherwise, the first dielectric layer, the second dielectric layer and the third dielectric layer may be the same or different and may be for instance comprise carbon-doped silicon oxide (SiOC), SiO₂, SiON, Si₃N₄ or a spin-on-glass.

In embodiments, the passivation layer may be formed as a side product of the etching process (typically a plasma etching process using a hydrocarbon and/or hydrofluorocarbon gas).

As used herein and unless provided otherwise, the hard mask may be any hard mask but is preferably a metal hard mask such as AIN or TiN.

In the above embodiment, in step c, the growing of the metal may fill the at least one via only partially (e.g. up to below the first dielectric layer or up to the level of the first dielectric layer) and the method further comprises after step c and before step d:
i. Removing the exposed passivation layer and removing the second sacrificial layer from within the trenches so as to expose part of the first dielectric layer,
ii. Removing the second dielectric layer,
iii. Applying a self-assembled monolayer selectively on the first dielectric layer, and
iv. Growing a metal on the self-assembled monolayer and on the metal so as to complete the filling of the at least one via and so as to fill the at least one trench.

This is advantageous because it permits, in a first step, to only fill parts of the vias, then only to start filling the trenches and the rest of the vias. If both vias and trenches were filled simultaneously from the beginning, the metal growing in trenches could in some instance cover the vias before the completion of their filling, thereby creating voids in the vias.

In embodiments, the method of the first aspect may further comprise after step a and before step b:
i. Filling the at least one via with a dielectric material so that the top surface of the dielectric material and the top surface of the first sacrificial layer are coplanar, thereby forming at least one dielectric pillar,
ii. Etching part of the first sacrificial layer until a top portion of the at least one dielectric pillar stands out of the first sacrificial layer,
iii. Overlaying what remains from the first sacrificial layer and the top portion of the at least one dielectric pillar with a conformal dielectric layer,
iv. Providing a second sacrificial layer on said conformal dielectric layer,
v. Providing a dielectric layer on said second sacrificial layer,
vi. Forming at least one trench in said dielectric layer, said second sacrificial layer and said conformal dielectric layer in such a way as to expose the top surface of the at least one dielectric pillar,
vii. Removing the dielectric pillar, thereby exposing the metal surface.

This represents an alternative way to have both vias and trenches formed in sacrificial layers. This permits the replacement of the sacrificial layers by a replacement dielectric layer which can be a low-k dielectric layer. This replacement layer will surround both the vias and the trenches and have a low amount of defects since it will not have suffered etching-induced damages. An advantage of this embodiment is that it enables a dual damascene process, i.e. a process where both the via and the trenches are formed prior to their filling with a metal. Such a process has the advantage that a single CMP is sufficient after metallization.

As used herein and unless provided otherwise, the conformal dielectric layer may for instance be a dielectric layer deposited by atomic layer deposition (ALD). For instance it can be a SiO₂ or a Si₃N₄ layer deposited by ALD.

In the method according to this alternative, in step c, the growing of the metal may fill the at least one via only partially (e.g. up to below the conformal dielectric layer or up to the level of the conformal dielectric layer) and the method may further comprise after step c and before step d:
i. Removing the second sacrificial layer from within the trenches so as to expose the underlying conformal dielectric layer,
ii. Applying a further self-assembled monolayer selectively on the exposed conformal dielectric,
iii. Growing a metal on the further self-assembled monolayer and on the metal so as to fill the at least one trench.

This is advantageous because it permits, in a first step, to only fill parts of the vias, then only to start filling the trenches and the rest of the vias. If both vias and trenches were filled simultaneously from the beginning, the metal growing in trenches could in some instance cover the vias before the completion of their filling, thereby creating voids in the vias.

In embodiments, wherein the structure comprises the first sacrificial layer, a first dielectric layer and a second sacrificial layer, and wherein the at least one via is cutting through each of these layers, the second sacrificial layer may further comprise at least one trench aligned with one or more of said at least one via, wherein in step c the growing of the metal fills the at least one via only up to below the first dielectric layer and wherein the method further comprises after step c and before step d :
i. Removing the second sacrificial layer from within the trenches so as to expose part the first dielectric layer,
ii. Applying a self-assembled monolayer selectively on the exposed first dielectric layer,
iii. Growing a metal on the self-assembled monolayer and on the metal so as to complete the filling of the at least one via and so as to fill the at least one trench.

This also represents an alternative way that permits to have both the vias and the trenches formed in sacrificial layers. This permits the replacement of the sacrificial layers by a replacement dielectric layer which can be a low-k dielectric layer. This replacement layer will surround both the vias and the trenches and have a low amount of defects since it will not have suffered etching-induced damages. An advantage of this embodiment is that it enables a dual damascene process, i.e. a process where both the via and the trenches are formed prior to their filling with a metal. Such a process has the advantage that a single CMP is sufficient after metallization.

In this alternative way, step a may comprise the steps of:
i. Providing a first oxide layer having a thickness crossed by at least one metal element,
ii. Overlaying the first oxide layer with an etch block layer,
iii. Overlying the etch block layer with said first sacrificial layer,
iv. Overlaying the first sacrificial layer with a first dielectric layer,
v. overlaying the first dielectric layer with a second sacrificial layer,
vi. overlaying the second sacrificial layer with a second dielectric layer,
vii. overlaying the second sacrificial layer with a hard mask,
viii. overlaying the hard mask with the patterned photoresist comprising at least one trench opening corresponding to at least one trench to be formed,
ix. etching the hard mask through said trench opening so as to expose part of the second dielectric layer,
x. removing the patterned photoresist,
xi. overlaying the metal hard mask and the exposed parts of the second dielectric layer with another patterned photoresist comprising at least one via opening corresponding to at least one via to be formed directly above said at least one trench,
xii. etching the second dielectric layer, the second sacrificial layer, the first dielectric layer, and the first sacrificial layer through said at least one via opening so as to expose part of the etch block layer,
xiii. removing the other patterned photoresist,
xiv. etching the exposed etch block layer and the second dielectric layer through the metal hard mask so as to expose the top metal surface of the metal element and so as to stop before reaching the first dielectric layer, and
xv. removing the hard mask and the second dielectric layer.

This embodiment has the advantage that both vias and trenches can be etched in a single etching step. This embodiment has the further advantage that by forming the trench before the via, the step of etching the via (step xii) becomes self-aligned due to the presence of the trench pattern in the hard mask. As a result, the alignment of the via and the trench can be improved since they are formed in a single etching step. This is particularly advantageous for narrow trenches and via having a lateral dimension of 10 nm or less or even 7 nm or less.

As used herein and unless provided otherwise, the term "etch block layer" may be any layer suitable for resisting to the etching conditions used to etch the sacrificial layer and which can be etched selectively to the metal surface exposed in step a. For instance, nitrogen-doped silicon carbide (SiCN) and oxygen-doped silicon carbide (SiCO) are suitable.

In any of the embodiments disclosed herein, step c may comprise growing a metal on the self-assembled monolayer so as to fill the at least one via and to cover the first sacrificial layer top surface, followed by chemical mechanical planarization until all metal present on the first sacrificial layer top surface has been removed.

In embodiments, the method of the first aspect may further comprise after step c and before step d:
i. Etching part of the first sacrificial layer until a top portion of each of the at least one metal pillar stands out of the first sacrificial layer,
ii. Overlaying what remains of the first sacrificial layer and the top portion of the at least one metal pillar with a conformal dielectric layer,
iii. Providing a second sacrificial layer on said conformal dielectric layer,
iv. Forming at least one trench in said second sacrificial layer in such a way as to expose the top surface of each of the at least one metal pillar and a portion of the conformal dielectric layer,
v. Applying a self-assembled monolayer selectively on the exposed conformal dielectric layer,
vi. Growing a metal on the self-assembled monolayer and on the exposed top surface of the at least one metal pillar, so as to fill the at least one trench.

In these embodiments, the vias are created and filled first, then the trenches are created and filled. This represents yet another alternative for having both the vias and the trenches formed in sacrificial layers.

In these embodiment, step iv may comprise the steps of:
- Overlaying the second sacrificial layer with a dielectric layer,
- Overlaying the dielectric layer with a patterned photoresist comprising at least one opening corresponding to at least one trench to be formed,
- Etching the dielectric layer and the second sacrificial layer through said at least one opening so as to expose the conformal dielectric layer covering the at least one metal pillar,
- Removing the dielectric layer and the exposed conformal dielectric layer covering the at least one metal pillar, and
- Etching the second sacrificial layer until the conformal dielectric layer is exposed in the at least one trench.

In these embodiments, step vi may comprise growing a metal on the self-assembled monolayer and on the exposed top surface of the at least one metal pillar, so as to fill the at least one trench and to cover the second sacrificial layer top surface, followed by chemical mechanical planarization until all metal present on the second sacrificial layer top surface has been removed.

The first aspect of the present invention can also be implemented for the formation of trenches alone.

In that case, the method may comprise:
a. Providing a structure comprising a sacrificial layer comprising at least one trench exposing a metal surface and a oxide surface,
b. Applying a self-assembled monolayer selectively on the exposed oxide surface,
c. Growing a metal on the self-assembled monolayer and on the metal surface so as to fill the at least one trench,
d. Replacing the sacrificial layer by a replacement dielectric layer having a dielectric constant of at most 3.9.

In any embodiment of the first aspect, step a may comprise the steps of:
i. Providing an oxide layer having a thickness crossed by at least one metal element,
ii. Overlaying the oxide layer with an etch block layer,
iii. Overlying the etch block layer with said first sacrificial layer,
iv. Overlaying the first sacrificial layer with a first dielectric layer,
v. Providing a patterned photoresist on top of the first dielectric layer, comprising at least one opening corresponding to the at least one through-hole to be formed,
vi. Etching the first dielectric layer and the first sacrificial layer so as to form the at least one through-hole, thereby exposing a portion of the etch block layer,
vii. Removing the photoresist,
viii. Removing the first dielectric layer and etching the portion of the etch block layer so as to expose the top metal surface of the metal element.

In any embodiments disclosed herein, step d may comprise:
i. Removing all sacrificial layers, the conformal dielectric layer if present and the first dielectric layer if present, thereby exposing the at least one metal element,
ii. Surrounding the metal element with a replacement dielectric layer having a dielectric constant of at most 3.9,
iii. Performing a chemical mechanical planarization of the replacement dielectric layer having a dielectric constant of at most 3.9 until the top surface of the metal element is exposed.

Also if the metal structure is a copper structure, prior to step ii, the exposed metal structure may be selectively coated with a barrier layer. To achieve selectivity for the barrier deposition, several options are available: in a first embodiment, a SAM inhibiting the barrier deposition can be deposited selectively on the etch block layer, then a barrier (e.g. a Ta/TaN barrier wherein Ta assure the adhesion of the barrier to the copper and TaN enhances the Cu diffusion barrier properties of the barrier) can be deposited selectively on the metal (e.g. by ALD or CVD). After deposition of the barrier, the SAM can be removed. This embodiment has the advantage of allowing the deposition of a relatively thin barrier. In a second embodiment, a SAM selective to the metal and suitable for use as a barrier can be used. In a third embodiment, a barrier can be grown selectively on the metal by means of an electroless process. NiB and CoWP barriers can be grown that way. An advantage of the second and third embodiment is that no SAM needs to be deposited on the etch block layer, which means that no SAM will need to be removed after the barrier deposition.

In any etching step of any embodiment of the present invention, the etching method may be adapted to the material to be etched as is well known to the person skilled in the art.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 to 10 show vertical cross-sections and a plan view of structures obtained after steps according to a first mode of realisation of the present invention.
Fig. 11 to 20 show vertical cross-sections and a plan view of structures obtained after steps according to a second mode of realisation of the present invention.
Fig. 21 to 33 show vertical cross-sections and a plan view of structures obtained after steps according to a third mode of realisation of the present invention.
Fig. 34 to 53 show vertical cross-sections and a plan view of structures obtained after steps according to a fourth mode of realisation of the present invention.
Fig. 54 to 71 show vertical cross-sections and a plan view of structures obtained after steps according to a fifth mode of realisation of the present invention.
Fig. 72 to 87 show vertical cross-sections and a plan view of structures obtained after steps according to a sixth mode of realisation of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

In each of the following figures, three schemes are shown. The top left scheme is a top view of the device in construction, the bottom left scheme is a vertical cross-section through the A-A' axis and the bottom right scheme is a vertical cross-section through the C-C' axis.

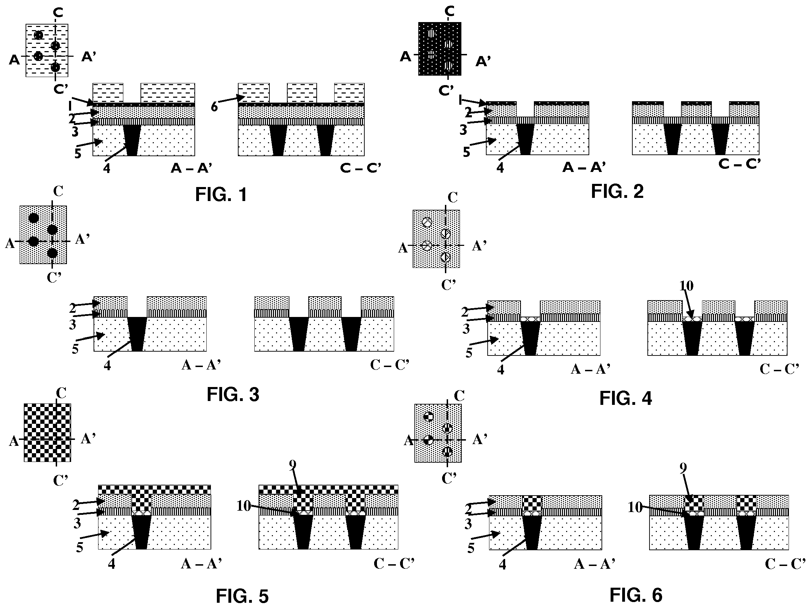

A first mode of realisation is depicted in Figs. 1-10.

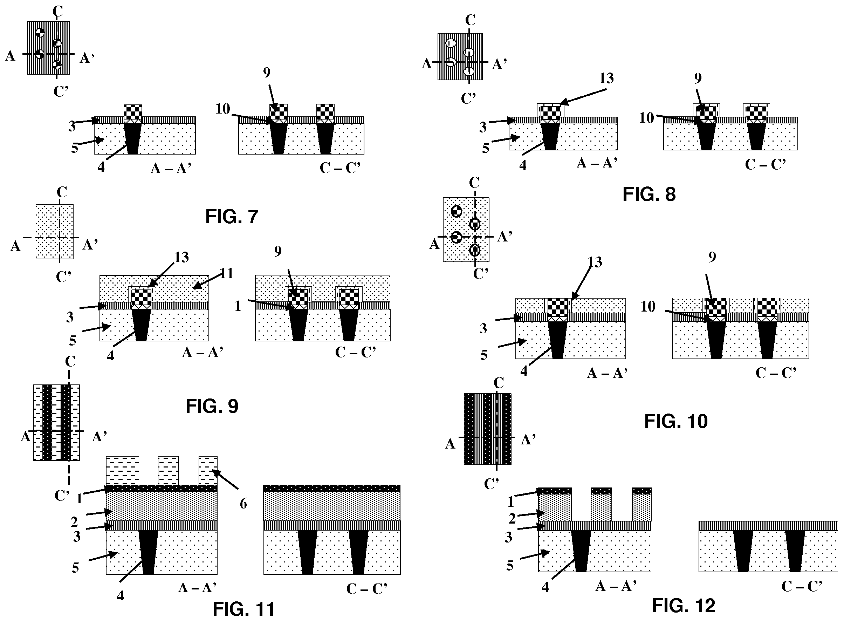

We are now referring to Fig. 1. A structure was provided which comprised an oxide layer (e.g. SiO₂) (5) having a thickness crossed by at least one metal (4) element (e.g. a tungsten plug), an etch block layer (e.g. a SiCN or SiCO layer) (3) overlying the oxide layer (5) and the metal (4) element, a sacrificial layer (e.g. an organic layer such as an APF layer) (2) overlying the etch block layer (3), a dielectric layer (e.g. a SiOC, a SiO₂/SiON, a spin-on-glass or a Si₃N₄ layer) (1) overlaying the sacrificial layer (2), and a patterned photoresist overlaying the dielectric layer (1). The patterned photoresist (6) comprised at least one opening corresponding to at least one via to be formed. That the opening corresponds to a via means that the opening has lateral dimensions suitable for obtaining the desired via. Typically, this means that the lateral dimensions of the opening are the same as those of the via. The photoresist was patterned by using a photolithographic mask. Fig. 2 shows the structure after etching through the at least one opening of the dielectric layer (1) and the sacrificial layer (2). The structure presented via holes cut through both the dielectric layer (1) and the sacrificial layer (2). A portion of the etch block layer (3) was thereby exposed. The photoresist is removed during or after this step. Fig. 3 shows the structure after that the dielectric layer (1) and the etch block layer (3) were etched simultaneously. The via therefore extended through the etch block layer (3) and the top metal (4) surface of the metal (4) element was exposed. Fig. 4 shows the structure after that a self-assembled monolayer (SAM) (10) was applied selectively on the exposed metal (4) surface. Fig. 5 shows the structure after that a metal (9) (here copper but alternative metals are possible) was grown on the SAM (10). The at least one via were thereby filled and formed at least one metal (9) structure (here metal pillars). The metal (9) overgrown the via and covered the sacrificial layer (2). Fig. 6 shows the structure after that the overgrown metal (9) was planarized by CMP until all metal (9) present on the sacrificial layer (2) top surface was removed. It resulted that the top surface of the metal (9) pillar and the top surface of the sacrificial layer (2) were co-planar. Fig. 7 shows the structure after that the sacrificial layer (2) was removed, thereby exposing the at least one metal (9) element. Fig. 8 shows the structure after that the at least one metal (9) element was selectively surrounded by a barrier (Ta/TaN) (13). The barrier (13) is advantageous when the metal (9) structure is copper. When the metal (9) is an alternative metal, a barrier is typically not necessary. To deposit the barrier, a hydrophobic SAM selective to the etch block layer was deposited to inhibit deposition of the barrier (13). The barrier (13) was then deposited by Atomic Layer Deposition (ALD) on the metal (9). Finally, the hydrophobic SAM was removed. An alternative to the use of ALD is CVD. To achieve selectivity for the barrier (13) deposition, other options are available: for instance, a SAM selective to the metal (9) and suitable for use as a barrier (13) can be used. Another option is to grow selectively a barrier (13) on the metal (9) by means of an electroless process. NiB and CoWP barriers (13) can be grown that way. An advantage of these alternative options is that no SAM needs to be deposited on the etch block layer (3), which means that no SAM will need to be removed after the barrier (13) deposition. However, such barriers tend to be thicker than ALD or CVD deposited barriers. Fig. 9 shows the structure after coating (and surrounding) of the at least one metal (9) element with a SiO₂ or low-k dielectric layer (11). Fig. 10 shows the structure after performance of a CMP until the top surface of the metal (9) element was exposed.

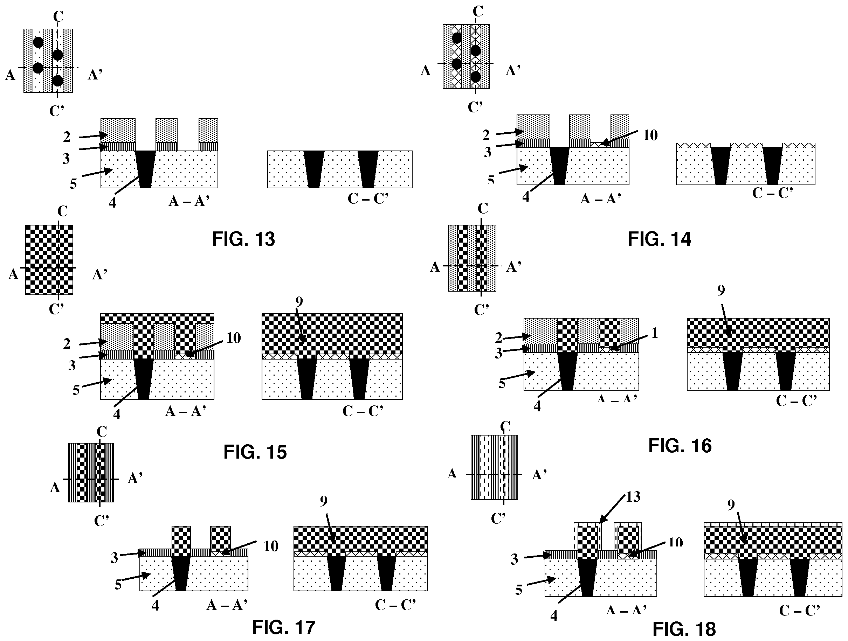

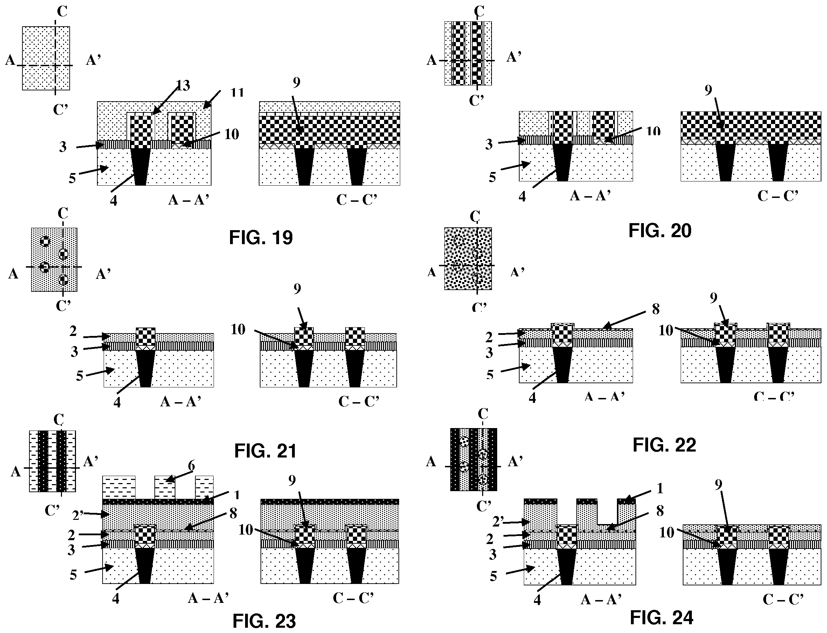

A second mode of realisation is depicted in Figs. 11-20. We are now referring to Fig. 11. A structure was provided which comprised an oxide layer (5) having a thickness crossed by at least one metal (4) element, an etch block layer (3) overlying the oxide layer (5) and the metal (4) element, a sacrificial layer (2) overlying the etch block layer (3), a dielectric layer (1) overlaying the sacrificial layer (2), and a patterned photoresist (6) overlaying the dielectric layer (1). The patterned photoresist (6) comprised at least one opening corresponding to at least one trench to be formed. That the opening corresponds to a trench means that the opening has lateral dimensions suitable for obtaining the desired trench. Typically, this means that the lateral dimensions of the opening are the same as those of the trench. The photoresist (6) was patterned by using a photolithographic mask. Fig. 12 shows the structure after etching through the at least one opening of the dielectric layer (1) and the sacrificial layer (2). The structure presented trench holes cut through both the dielectric layer (1) and the sacrificial layer (2). A portion of the etch block layer (3) was thereby exposed. The photoresist is removed during or after this step. Fig. 13 shows the structure after that the dielectric layer (1) and the etch block layer (3) were etched simultaneously. The trenches therefore extended through the etch block layer (3) and the top metal (4) surface of the metal (4) element was exposed. Fig. 14 shows the structure after that a self-assembled monolayer (SAM) (10) was applied selectively on the exposed dielectric surface (5). Fig. 15 shows the structure after that a metal (9) (here copper but alternative metals are possible) was grown on the SAM (10). The at least one trench was thereby filled and formed at least one metal (9) structure (here metal lines). The metal (9) overgrown the trench and covered the sacrificial layer (2). Fig. 16 shows the structure after that the overgrown metal (9) was planarized by CMP until all metal (9) present on the sacrificial layer (2) top surface was removed. It resulted that the top surface of the metal (9) lines and the top surface of the sacrificial layer (2) were co-planar. Fig. 17 shows the structure after that the sacrificial layer (2) was removed, thereby exposing the at least one metal (9) element. Fig. 18 shows the structure after that the at least one metal (9) element was selectively surrounded by a barrier (Ta/TaN) (13). To deposit the barrier, a hydrophobic SAM selective to the etch block layer was deposited to inhibit deposition of the barrier (13). The barrier (13) was then deposited by Atomic Layer Deposition (ALD) on the metal (9). Fig. 19 shows the structure after coating (and surrounding) of the at least one metal (9) element with a SiO₂ or low-k dielectric layer (11). Fig. 20 shows the structure after performance of a CMP until the top surface of the metal (9) element was exposed.

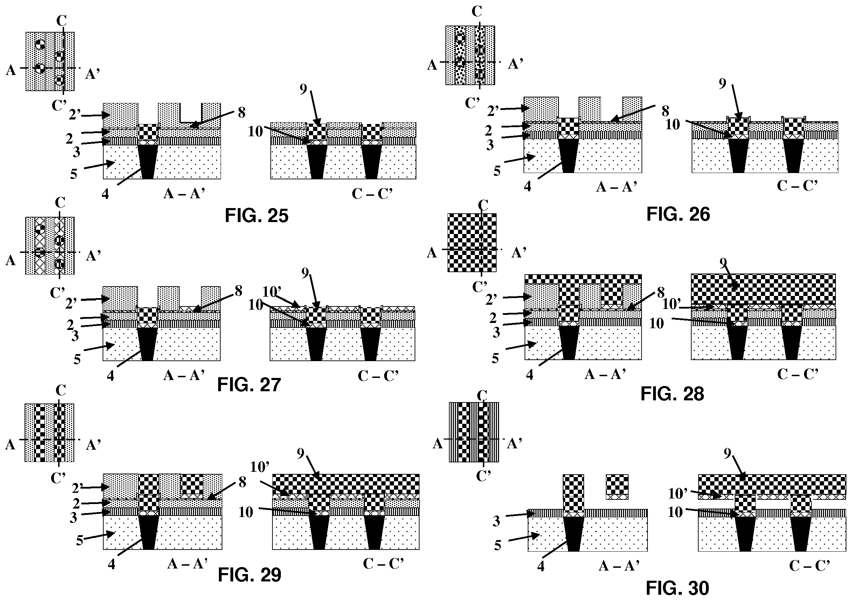

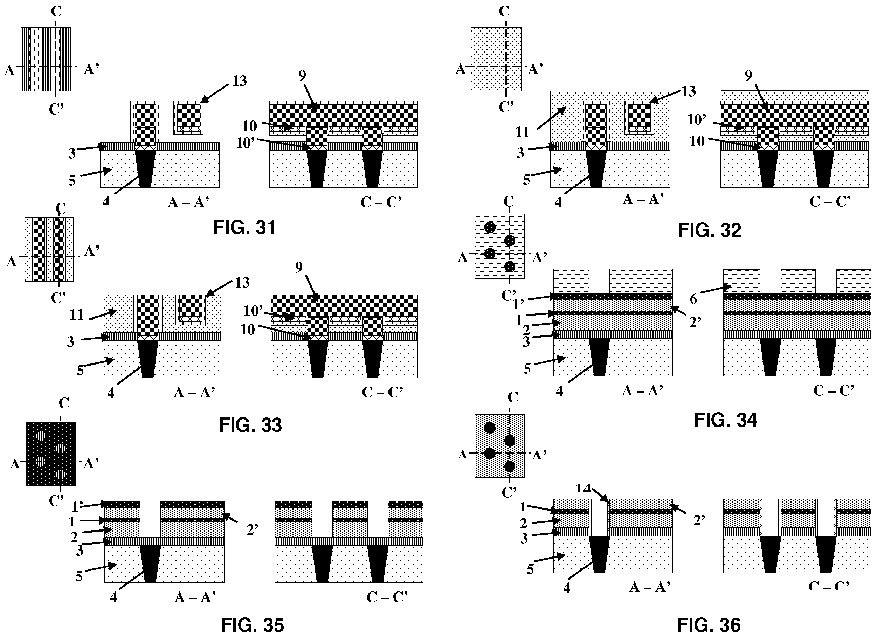

A third mode of realisation is depicted in Figs. 1-6 and 21-33. This third mode of realisation followed the first mode of realisation up to and including Fig. 6. Fig. 21 shows the structure after that part of the sacrificial layer was etched until a top portion of each of the at least one metal pillar stood out of the sacrificial layer. Fig. 22 shows the structure after that what remained from the sacrificial layer (2) and the top portion of the at least one metal (9) pillar was overlayed with a conformal dielectric layer (SiO₂) (8) deposited by ALD. Fig. 23 shows the structure after that a second sacrificial layer (e.g. an organic layer such as a spin-on carbon or an APF layer) (2') was provided (e.g. by spin coating) on said conformal dielectric layer (8), that a dielectric layer (e.g. a spin-on glass or a SiOC layer) (1) was overlaid (e.g. by spin coating) on the second sacrificial layer (2'), and that the second dielectric layer (1) was overlaid with a patterned photoresist (6) comprising at least one opening corresponding to at least one trench to be formed. Fig. 24 shows the structure after that the dielectric layer (1) and the second sacrificial layer (2') were etched through said at least one opening so as to expose the conformal dielectric layer (8) covering the at least one metal (9) pillar The etching was stopped when the conformal dielectric layer (8) covering the metal (9) pillar was reached. This left some of the second sacrificial layer (2') unetched between the vias within the trenches. Fig. 25 shows the structure after that the dielectric layer (1) and the exposed conformal dielectric layer (8) covering the at least one metal (9) pillar were removed (this can be performed via a short oxide breakthrough using a diluted HF aqueous solution or via dry etching). Fig. 26 shows the structure after that the second sacrificial layer (2') was etched until the conformal dielectric layer (8) was exposed in the at least one trench. Fig. 27 shows the structure after that a self-assembled monolayer (10) was selectively applied on the exposed conformal dielectric layer (8). Fig. 28 shows the structure after a metal (9) was grown on the self-assembled monolayer (10) and on the exposed top surface of the at least one metal (9) pillar, so as to fill the at least one trench and to cover the second sacrificial layer (2') top surface. Fig. 29 shows the structure after that chemical mechanical planarization was performed until all metal (9) present on the second sacrificial layer (2') top surface has been removed. Fig. 30 shows the structure after that the first and second sacrificial layers (2, 2') as well as the conformal dielectric layer (8) were removed, thereby exposing the at least one metal (9) element. Fig. 31 shows the structure after that the at least one metal (9) element was surrounded by a barrier (Ta/TaN) (13). To deposit the barrier, a hydrophobic SAM selective to the etch block layer (3) was deposited to inhibit deposition of the barrier (13). The barrier (13) was then deposited by Atomic Layer Deposition (ALD) on the metal (9). Fig. 32 shows the structure after coating (and surrounding) of the at least one metal (9) element with a SiO₂ or low-k dielectric layer (11). Fig. 33 shows the structure after performance of a CMP until the top surface of the metal (9) element was exposed.

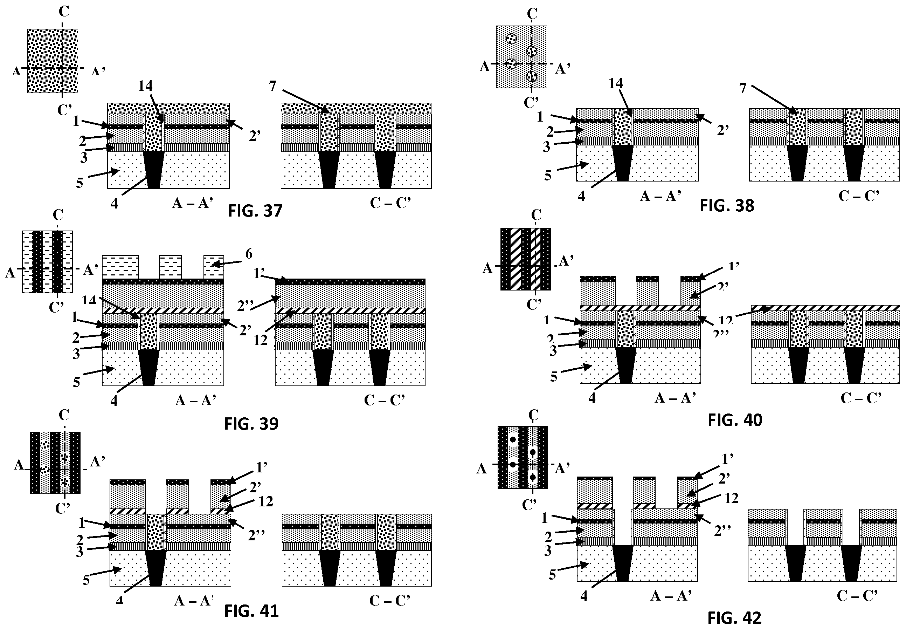

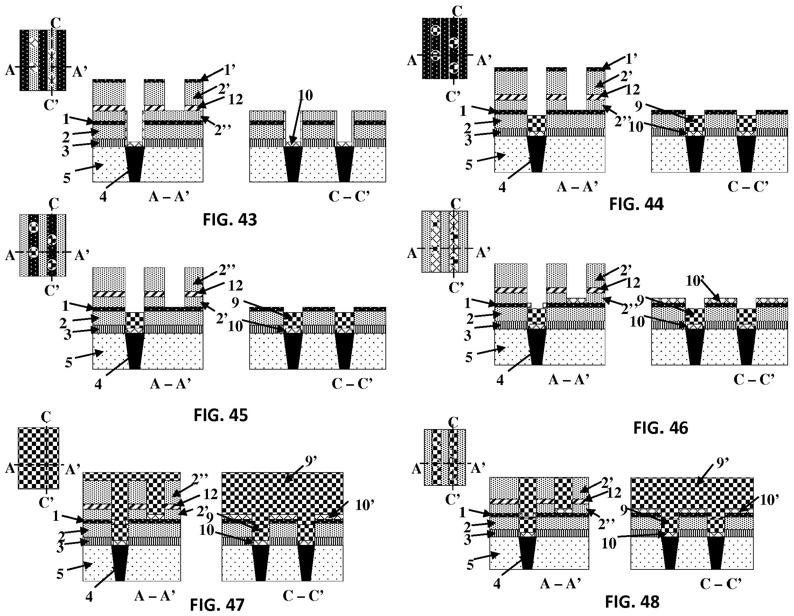

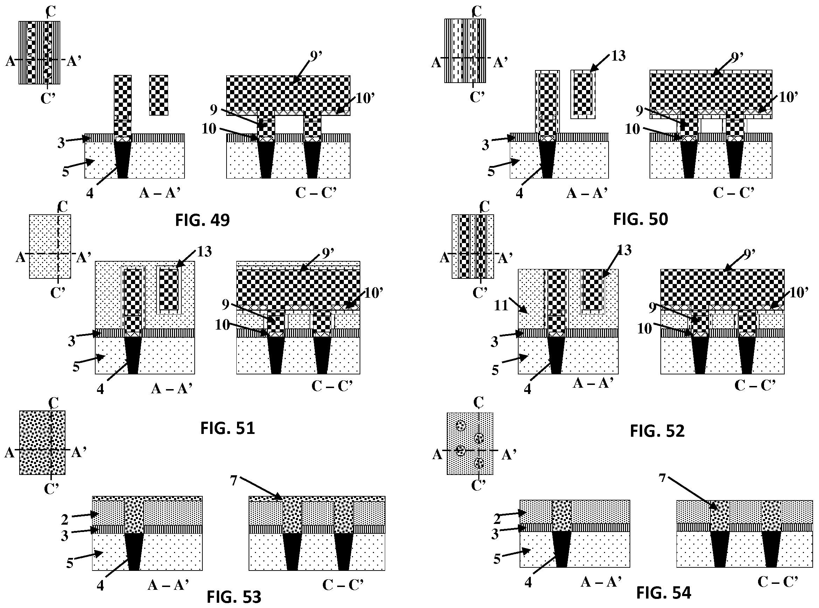

A fourth mode of realisation is depicted in Figs. 34-53. We are now referring to Fig. 34. A structure was provided which comprised an oxide layer (5) having a thickness crossed by at least one metal (4) element, an etch block layer (3) overlying the oxide layer (5) and the metal (4) element, a sacrificial layer (2) overlying the etch block layer (3), a dielectric layer (1) overlaying the sacrificial layer (2), a second sacrificial layer (2') overlying the dielectric layer (1), a second dielectric layer (1') overlaying the second sacrificial layer (2'), and a patterned photoresist overlaying the dielectric layer (1). The patterned photoresist (6) comprised at least one opening corresponding to at least one via to be formed. The photoresist was patterned by using a photolithographic mask. Fig. 35 shows the structure after etching, through the at least one opening, of the second dielectric layer (1'), the second sacrificial layer (2'), the first dielectric layer (1) and the first sacrificial layer (2). The structure presented via holes cut through the second dielectric layer (1'), the second sacrificial layer (2'), the first dielectric layer (1) and the first sacrificial layer (2). A portion of the etch block layer (3) was thereby exposed. The photoresist is removed during or after this step. Fig. 36 shows the structure after that the dielectric layer (1) and the etch block layer (3) were etched simultaneously and that the side walls were passivated with a hydrophilic polymer (14). The via extended through the etch block layer (3), and the top metal (4) surface of the metal (4) element was exposed. The hydrophilic side walls were introduced to permit the easy removal of the dielectric material (7). Fig. 37 shows the structure after that the at least one via was filled with a dielectric material (7) so that the top surface of the second sacrificial layer (2') was covered with the dielectric material (7). Fig. 38 shows the structure after that the dielectric material was etched until the top surface of the dielectric material (7) and the top surface of the second sacrificial layer (2') were coplanar. This etching was performed with HF. Both vapour HF and aqueous HF can be used. Fig. 39 shows the structure after the first step of the trench patterning. For introducing trenches in the structure, the dielectric material (7) and the second sacrificial layer (2') were overlaid with a hard mask (AlN) (12), the hard mask (12) was overlaid with a third sacrificial layer (2"), and the third sacrificial layer (2") was overlaid with a second dielectric layer (1'). Fig. 40 shows the structure after one or more trenches were etched through the dielectric layer (1'), and the third sacrificial layer (2") so that at least one of said trenches is aligned with said at least one via. Fig. 41 shows the structure after that the metal hard mask (12) was etched. Fig. 42 shows the structure after that the dielectric material (7) was removed, thereby exposing the metal (4) surface. Fig. 43 shows the structure after that a self-assembled monolayer (SAM) (10) was applied selectively on the exposed metal (4) surface. Fig. 44 shows the structure after that the metal (9) was grown to fill the at least one via only up to below the dielectric layer (1). Fig. 45 shows the structure after that the hydrophilic polymer (14) was removed and after that the second sacrificial layer (2') was removed from within the trenches so as to expose the dielectric layer (1). Fig. 46 shows the structure after that the second dielectric layer (1') was removed. Fig. 47 shows the structure after that a self-assembled monolayer (10) was applied selectively on the dielectric layer (1). Fig. 48 shows the structure after that a metal (9) was grown on the self-assembled monolayer (10) and on the metal (9) so as to complete the filling of the at least one via and so as to fill the at least one trenches and covering the second sacrificial layer (2'). Fig. 49 shows the structure after that chemical mechanical planarization was performed until all metal (9) present on the second sacrificial layer (2') top surface was removed. Fig. 50 shows the structure after that the first and second sacrificial layers (2, 2') as well as the hard mask (12) were removed, thereby exposing the at least one metal (9) element. Fig. 51 shows the structure after that the at least one metal (9) element was surrounded by a barrier (Ta/TaN) (13). To deposit the barrier, a hydrophobic SAM selective to the etch block layer (3) was deposited to inhibit deposition of the barrier (13). The barrier (13) was then deposited by Atomic Layer Deposition (ALD) on the metal (9). Fig. 52 shows the structure after coating (and surrounding) of the at least one metal (9) element with a SiO₂ or low-k dielectric layer (11). Fig. 53 shows the structure after performance of a CMP until the top surface of the metal (9) element was exposed.

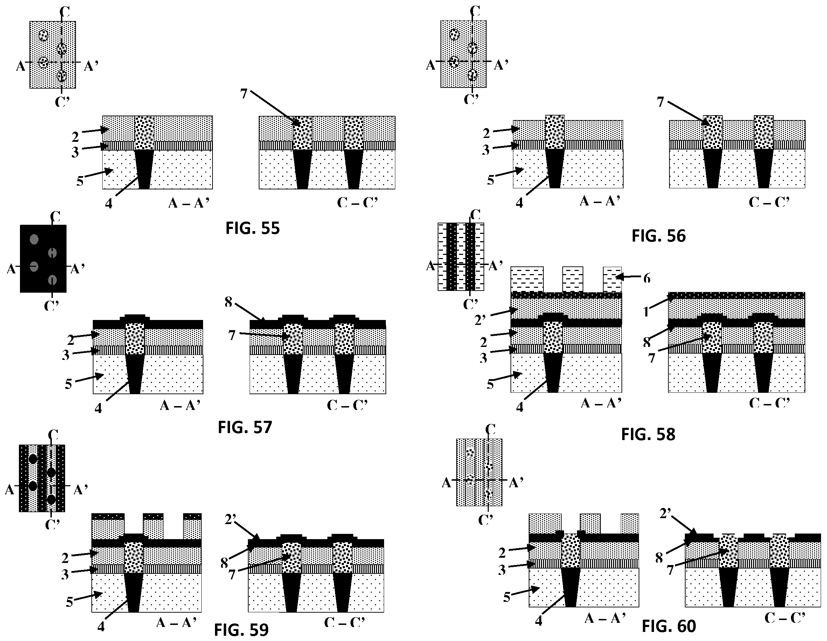

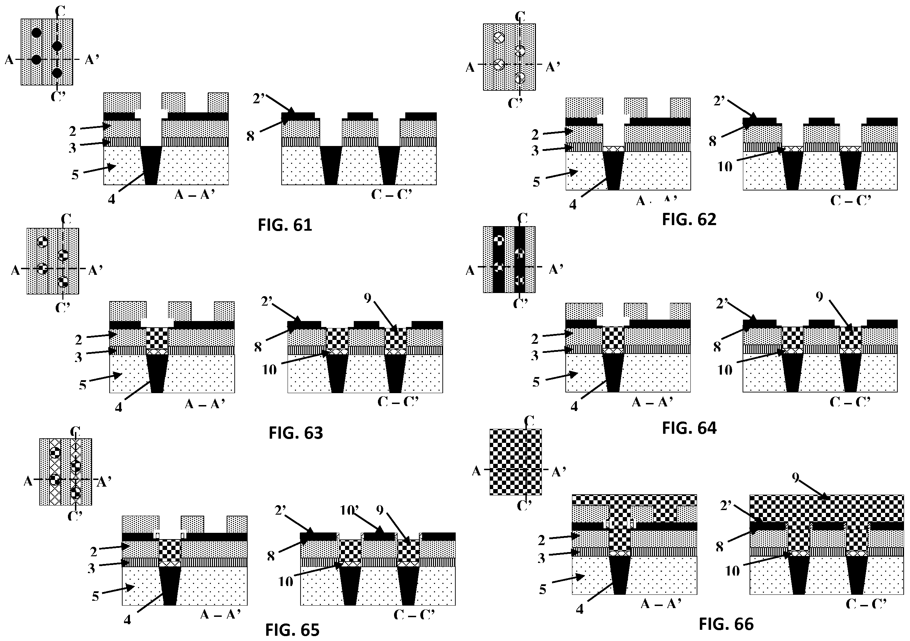

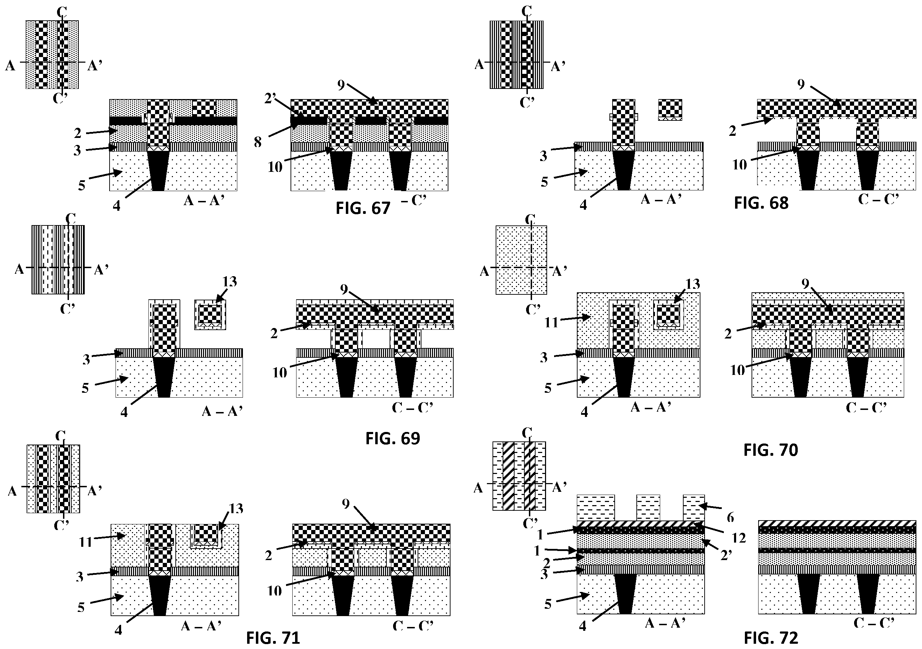

A fifth mode of realisation is depicted in Figs. 1-3 and 54-71. This fifth mode of realisation followed the first mode of realisation up to and including Fig. 3. Fig. 54 shows the structure after that the at least one via was filled with a dielectric material (7) until the top surface of the sacrificial layer (2) was covered with the dielectric material (7). Fig. 55 shows the structure after that the dielectric material was etched until the top surface of the dielectric material (7) and the top surface of the sacrificial layer (2) were coplanar. This etching was performed with HF. Both vapour HF and aqueous HF can be used. Fig. 56 shows the structure after that part of the sacrificial layer (2) was etched until a top portion of the at least one dielectric (7) pillar stands out of the sacrificial layer (2). Fig. 57 shows the structure after that what remains from the sacrificial layer (2) and the top portion of the at least one dielectric (7) pillar was overlaid with a conformal dielectric layer (8). Fig. 58 shows the structure after that a second sacrificial layer (2') was provided on said conformal dielectric layer (8), that a dielectric layer (1) was provided on said second sacrificial layer (2'), and a patterned photoresist (6) overlaying the dielectric layer (1). The patterned photoresist (6) comprised at least one opening corresponding to at least one trench to be formed. Fig. 59 shows the structure after that the dielectric layer (1) and the second sacrificial layer (2') were etched through said at least one opening so as to expose the conformal dielectric layer (8) covering the at least one dielectric (7) pillar The etching was stopped when the conformal dielectric layer (8) covering the dielectric (7) pillar was reached. This left some of the second sacrificial layer (2') unetched between the vias within the trenches. Fig. 60 shows the structure after that the dielectric layer (1) and the exposed conformal dielectric layer (8) covering the at least one dielectric (7) pillar were removed (this can be performed via a short oxide breakthrough using a diluted HF aqueous solution or via dry etching). Fig. 61 shows the structure after that the dielectric material (7) was removed, thereby exposing the metal (4) surface. Fig. 62 shows the structure after that a self-assembled monolayer (SAM) (10) was applied selectively on the exposed metal (4) surface. Fig. 63 shows the structure after that the metal (9) was grown to fill the at least one via only up to below the conformal dielectric layer (8). Fig. 64 shows the structure after that the second sacrificial layer (2') was etched until the conformal dielectric layer (8) was exposed in the at least one trench. Fig. 65 shows the structure after that a self-assembled monolayer (10) was selectively applied on the exposed conformal dielectric layer (8). Fig. 66 shows the structure after a metal (9) was grown on the self-assembled monolayer (10) and on the exposed top surface of the at least one metal (9) pillar, so as to fill the at least one trench and to cover the second sacrificial layer (2') top surface. Fig. 67 shows the structure after that chemical mechanical planarization was performed until all metal (9) present on the second sacrificial layer (2') top surface has been removed. Fig. 68 shows the structure after that the first and second sacrificial layers (2,2') as well as the conformal dielectric layer (8) were removed, thereby exposing the at least one metal (9) element. Fig. 69 shows the structure after that the at least one metal (9) element was surrounded by a barrier (Ta/TaN) (13). To deposit the barrier, a hydrophobic SAM selective to the etch block layer (3) was deposited to inhibit deposition of the barrier (13). The barrier (13) was then deposited by Atomic Layer Deposition (ALD) on the metal (9). Fig. 70 shows the structure after coating (and surrounding) of the at least one metal (9) element with a SiO₂ or low-k dielectric layer (11). Fig. 71 shows the structure after performance of a CMP until the top surface of the metal (9) element was exposed.

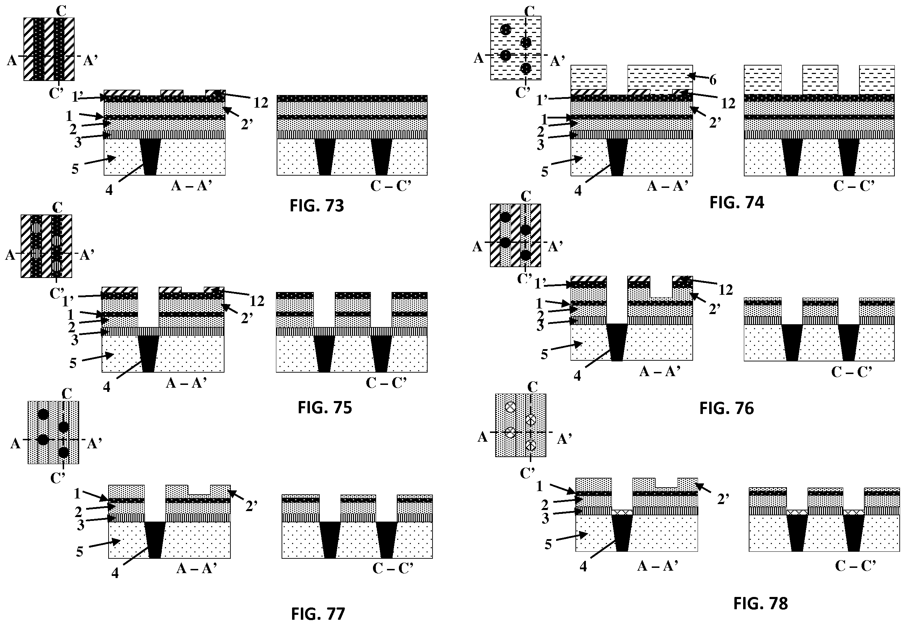

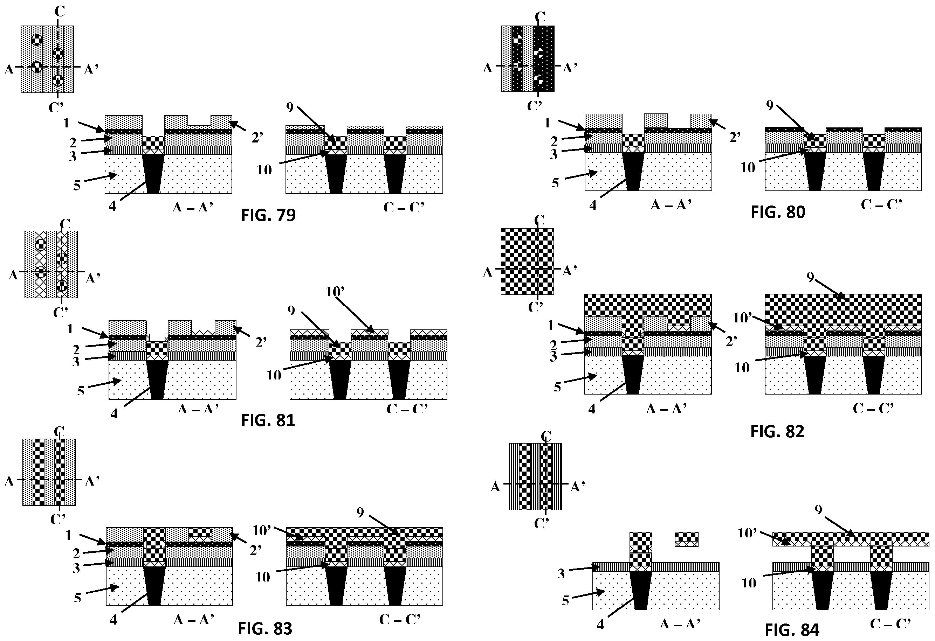

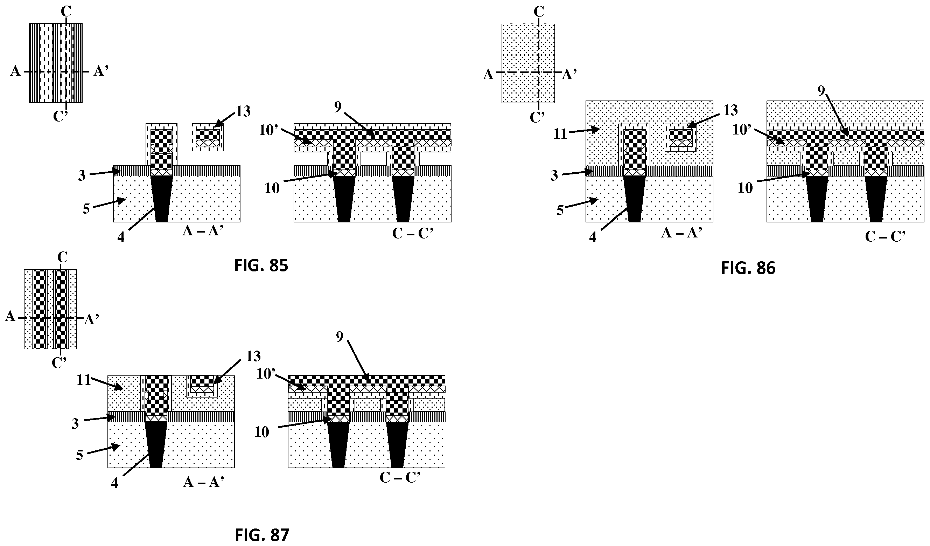

A sixth mode of realisation is depicted in Figs. 72-87. We are now referring to Fig. 72. A structure was provided which comprised an oxide layer (5) having a thickness crossed by at least one metal (4) element, an etch block layer (3) overlying the oxide layer (5) and the metal (4) element, a sacrificial layer (2) overlying the etch block layer (3), a dielectric layer (1) overlaying the sacrificial layer (2), a second sacrificial layer (2') overlying the dielectric layer (1), a second dielectric layer (1') overlaying the second sacrificial layer (2'), a metal hard mask (12) overlaying the second dielectric (1'), and a patterned photoresist overlaying the metal hard mask (12). The patterned photoresist (6) comprised at least one opening corresponding to at least one trench to be formed. The photoresist was patterned by using a photolithographic mask. Fig. 73 shows the structure after that the metal hard mask (12) was etched through the trench opening and that the patterned photoresist was removed. Part of the second dielectric layer (1') is thereby exposed. Fig. 74 shows the structure after that the metal hard mask (12) and the exposed parts of the second dielectric layer (1') were overlaid with another patterned photoresist (6') comprising at least one via opening corresponding to at least one via to be formed directly above said at least one trench. Fig. 75 shows the structure after that the second dielectric layer (1') and the second sacrificial layer (2') were etched through said at least one via opening and that the other patterned photoresist (6') was removed, thereby exposing part of the etch block layer (3). Fig. 76 shows the structure after that the exposed etch block layer (3) and the second dielectric layer (1') were etched through the metal hard mask so as to expose the top metal (4) surface of the metal (4) element and so as to stop before reaching the first dielectric layer (1). Fig. 77 shows the structure after that the hard mask (12) and the second dielectric layer (1') were removed. Fig. 78 shows the structure after that a self-assembled monolayer (SAM) (10) was applied selectively on the exposed metal (4) surface. Fig. 79 shows the structure after that the metal (9) was grown to fill the at least one via only up to below the first dielectric layer (1). Fig. 80 shows the structure after that the second sacrificial layer (2') was etched until the first dielectric layer (1) was exposed in the at least one trench. Fig. 81 shows the structure after that a self-assembled monolayer (10) was selectively applied on the exposed first dielectric layer (1). Fig. 82 shows the structure after a metal (9) was grown on the self-assembled monolayer (10) and on the exposed top surface of the at least one metal (9) pillar, so as to fill the at least one trench and to cover the second sacrificial layer (2') top surface. Fig. 83 shows the structure after that chemical mechanical planarization was performed until all metal (9) present on the second sacrificial layer (2') top surface has been removed. Fig. 84 shows the structure after that the first and second sacrificial layers (2,2') as well as the conformal dielectric layer (8) were removed, thereby exposing the at least one metal (9) element. Fig. 85 shows the structure after that the at least one metal (9) element was surrounded by a barrier (Ta/TaN) (13). To deposit the barrier, a hydrophobic SAM selective to the etch block layer (3) was deposited to inhibit deposition of the barrier (13). The barrier (13) was then deposited by Atomic Layer Deposition (ALD) on the metal (9). Fig. 86 shows the structure after coating (and surrounding) of the at least one metal (9) element with a SiO₂ or low-k dielectric layer (11). Fig. 87 shows the structure after performance of a CMP until the top surface of the metal (9) element was exposed.

## Claims

1. A method for fabricating a semiconductor device, comprising:
a. Providing a structure comprising a first sacrificial layer (2) comprising at least one through-hole exposing a metal (4) surface and optionally an oxide (5) surface,
b. Applying a self-assembled monolayer (10) selectively on the exposed metal (4) surface and/or on the oxide (5) surface,
c. Growing a metal (9) on the self-assembled monolayer (10) and on the exposed metal (4) surface if no self-assembled monolayer (10) is present thereon, so as to fill the at least one through-hole, thereby forming at least one metal (9) structure,
d. Replacing the first sacrificial layer (2) by a replacement dielectric layer (11) having a dielectric constant of at most 3.9.

2. The method according to claim 1, wherein:
- the at least one through-hole exposing a metal (4) surface and optionally an oxide (5) surface is at least one via exposing a metal (4) surface,
- step b of applying a self-assembled monolayer (10) selectively on the exposed metal (4) surface and/or on the oxide (5) surface consists in applying a self-assembled monolayer (10) selectively on the exposed metal (4) surface, and
- step c of growing a metal (9) on the self-assembled monolayer (10) and on the exposed metal (4) surface if no self-assembled monolayer (10) is present thereon, so as to fill the at least one through-hole, thereby forming at least one metal (9) structure, consists in growing a metal (9) on the self-assembled monolayer (10) so as to fill the at least one via, thereby forming at least one metal (9) pillar,

3. The method according to claim 2, wherein the structure further comprises a first dielectric layer (1) overlaying the first sacrificial layer (2), and a second sacrificial layer (2') overlaying the first dielectric layer (1), wherein the at least one via cuts through the first sacrificial layer (2), the first dielectric layer (1), and the second sacrificial layer layer (2'), the method further comprising after step a and before step b:
i. Covering the side walls of the via with a passivation layer (14),
ii. Filling the at least one via with a dielectric material (7) so that the top surface of the dielectric material (7) and the top surface of the second sacrificial layer (2') are coplanar,
iii. Overlaying the dielectric material (7) and the second sacrificial layer (2') with a hard mask (12),
iv. Overlaying the hard mask (12) with a third sacrificial layer (2"),
v. Overlaying the third sacrificial layer (2") with a second dielectric layer (1'),
vi. Etching one or more trenches through the second dielectric layer (1'), the third sacrificial layer (2"), and the hard mask (12) so that at least one of said trenches is aligned with at least one via, thereby exposing the dielectric material (7) and part of the second sacrificial layer (2'),
vii. Removing the dielectric material (7), thereby exposing the metal (4) surface.

4. The method according to claim 3, wherein in step c the growing of the metal (9) fills the at least one via only up to below the first dielectric layer (1) and wherein the method further comprises after step c and before step d:
i. Removing the exposed passivation layer (14) and removing the second sacrificial layer (2') from within the trenches so as to expose part of the first dielectric layer (1),
ii. Removing the second dielectric layer (1'),
iii. Applying a self-assembled monolayer (10) selectively on the first dielectric layer (1),
iv. Growing a metal (9) on the self-assembled monolayer (10) and on the metal (9) so as to complete the filling of the at least one via and so as to fill the at least one trench,

5. The method according to claim 2, further comprising after step a and before step b:
i. Filling the at least one via with a dielectric material (7) so that the top surface of the dielectric material (7) and the top surface of the first sacrificial layer (2) are coplanar, thereby forming at least one dielectric (7) pillar,
ii. Etching part of the first sacrificial layer (2) until a top portion of the at least one dielectric (7) pillar stands out of the first sacrificial layer (2),
iii. Overlaying what remains from the first sacrificial layer (2) and the top portion of the at least one dielectric (7) pillar with a conformal dielectric layer (8),
iv. Providing a second sacrificial layer (2') on said conformal dielectric layer (8),
v. Providing a dielectric layer (1) on said second sacrificial layer (2'),
vi. Forming at least one trench in said dielectric layer (1), said second sacrificial layer (2') and said conformal dielectric layer (8) in such a way as to expose the top surface of the at least one dielectric (7) pillar,
vii. Removing the dielectric (7) pillar, thereby exposing the metal (4) surface.

6. The method according to claim 2, wherein the structure comprises the first sacrificial layer (2), a first dielectric layer (1) and a second sacrificial layer (2'), wherein the at least one via is cutting through each of these layers, the second sacrificial layer (2') further comprising at least one trench aligned with one or more of said at least one via, wherein in step c the growing of the metal (9) fills the at least one via only up to below the first dielectric layer (1) and wherein the method further comprises after step c and before step d :
i. Removing the second sacrificial layer (2') from within the trenches so as to expose part the first dielectric layer (1),
ii. Applying a self-assembled monolayer (10) selectively on the exposed first dielectric layer (1),
iii. Growing a metal (9) on the self-assembled monolayer (10) and on the metal (9) so as to complete the filling of the at least one via and so as to fill the at least one trench.

7. The method according to claim 5, wherein in step c the growing of the metal (9) fills the at least one via only up to below the conformal dielectric layer (8) and wherein the method further comprises after step c and before step d:
i. Removing the second sacrificial layer (2') from within the trenches so as to expose the underlying conformal dielectric layer (8),
ii. Applying a further self-assembled monolayer (10') selectively on the exposed conformal dielectric (8),
iii. Growing a metal (9) on the further self-assembled monolayer (10') and on the metal (9) so as to fill the at least one trench.

8. The method according to claim 2, wherein step c comprises growing a metal (9) on the self-assembled monolayer (10) so as to fill the at least one via and to cover the first sacrificial layer (2) top surface, followed by chemical mechanical planarization until all metal (9) present on the first sacrificial layer (2) top surface has been removed.

9. The method according to claim 2, further comprising after step c and before step d:
i. Etching part of the first sacrificial layer (2) until a top portion of each of the at least one metal (9) pillar stands out of the first sacrificial layer (2),
ii. Overlaying what remains of the first sacrificial layer (2) and the top portion of the at least one metal (9) pillar with a conformal dielectric layer (8),
iii. Providing a second sacrificial layer (2') on said conformal dielectric layer (8),
iv. Forming at least one trench in said second sacrificial layer (2') in such a way as to expose the top surface of each of the at least one metal (9) pillar and a portion of the conformal dielectric layer (8),
v. Applying a self-assembled monolayer (10) selectively on the exposed conformal dielectric layer (8),
vi. Growing a metal (9) on the self-assembled monolayer (10) and on the exposed top surface of the at least one metal (9) pillar, so as to fill the at least one trench.

10. The method according to claim 9, wherein step iv comprises the steps of:
- Overlaying the second sacrificial layer (2') with a dielectric layer (1),
- Overlaying the dielectric layer (1) with a patterned photoresist (6) comprising at least one opening corresponding to at least one trench to be formed,
- Etching the dielectric layer (1) and the second sacrificial layer (2') through said at least one opening so as to expose the conformal dielectric layer (8) covering the at least one metal (9) pillar,
- Removing the dielectric layer (1) and the exposed conformal dielectric layer (8) covering the at least one metal (9) pillar, and
- Etching the second sacrificial layer (2') until the conformal dielectric layer (8) is exposed in the at least one trench.

11. The method according to claim 9 or 10 wherein step vi comprises growing a metal (9) on the self-assembled monolayer (10) and on the exposed top surface of the at least one metal (9) pillar, so as to fill the at least one trench and to cover the second sacrificial layer (2') top surface, followed by chemical mechanical planarization until all metal (9) present on the second sacrificial layer (2') top surface has been removed.

12. A method according to claim 1, wherein:
- The at least one through-hole exposing a metal surface and optionally an oxide (5) surface is at least one trench exposing a metal (4) surface and an oxide (5) surface,
- Step b of applying a self-assembled monolayer (10) selectively on the exposed metal (4) surface and/or on the oxide (5) surface consists in applying a self-assembled monolayer (10) selectively on the exposed oxide (5) surface,
- Step c of growing a metal (9) on the self-assembled monolayer (10) and on the exposed metal (4) surface if no self-assembled monolayer (10) is present thereon so as to fill the at least one through-hole, thereby forming at least one metal (9) structure consists in growing a metal (9) on the self-assembled monolayer (10) and on the metal surface (4) so as to fill the at least one trench.

13. The method according to any one of the preceding claims, wherein step a comprises the steps of:
i. Providing an oxide layer (5) having a thickness crossed by at least one metal (4) element,
ii. Overlaying the oxide layer (5) with an etch block layer (3),
iii. Overlying the etch block layer (3) with said first sacrificial layer (2),
iv. Overlaying the first sacrificial layer (2) with a first dielectric layer (1),
v. Providing a patterned photoresist (6) on top of the first dielectric layer (1), comprising at least one opening corresponding to the at least one through-hole to be formed,
vi. Etching the first dielectric layer (1) and the first sacrificial layer (2) so as to form the at least one through-hole, thereby exposing a portion of the etch block layer (3),
vii. Removing the photoresist (6),
viii. Removing the first dielectric layer (1) and etching the portion of the etch block layer (3) so as to expose the top metal (4) surface of the metal (4) element.

14. The method according to claim 6, wherein step a comprises the steps of:
i. Providing a first oxide layer (5) having a thickness crossed by at least one metal element (4),
ii. Overlaying the first oxide layer (5) with an etch block layer (3),
iii. Overlying the etch block layer (3) with said first sacrificial layer (2),
iv. Overlaying the first sacrificial layer (2) with a first dielectric layer (1),
v. overlaying the first dielectric layer (1) with a second sacrificial layer (2'),
vi. overlaying the second sacrificial layer (2') with a second dielectric layer (1'),
vii. overlaying the second sacrificial layer (2') with a hard mask (12),
viii. overlaying the hard mask (12) with the patterned photoresist (6) comprising at least one trench opening corresponding to at least one trench to be formed,
ix. etching the hard mask (12) through said trench opening so as to expose part of the second dielectric layer (1'),
x. removing the patterned photoresist (6),
xi. overlaying the hard mask (12) and the exposed parts of the second dielectric layer (1') with another patterned photoresist (6') comprising at least one via opening corresponding to at least one via to be formed directly above said at least one trench,
xii. etching the second dielectric layer (1'), the second sacrificial layer (2'), the first dielectric layer (1), and the first sacrificial layer (2) through said at least one via opening so as to expose part of the etch block layer (3),
xiii. removing the other patterned photoresist (6'),
xiv. etching the exposed etch block layer and the second dielectric layer (1') through the hard mask so as to expose the top metal (4) surface of the metal (4) element and so as to stop before reaching the first dielectric layer (1), and xv. removing the hard mask (12) and the second dielectric layer (1').

15. The method according to any one of the preceding claims, wherein step d comprises the steps of:
i. Removing all sacrificial layers (2, 2', 2"), the conformal dielectric layer (8) if present and the first dielectric layer (1) if present, thereby exposing the at least one metal (9) element,
ii. Surrounding the metal (9) element with a replacement dielectric layer (11) having a dielectric constant of at most 3.9,
iii. Performing a chemical mechanical planarization of the replacement dielectric layer (11) having a dielectric constant of at most 3.9 until the top surface of the metal (9) element is exposed.

16. The method of claim 15, wherein the metal (9) structure is a copper structure and wherein prior to step ii, the exposed metal (9) structure is selectively coated with a barrier layer (13).

## Patentansprüche

1. Verfahren zur Herstellung einer Halbleitervorrichtung, Folgendes umfassend:
a. Bereitstellen einer Struktur, eine erste Opferschicht (2) umfassend, die zumindest ein Durchgangsloch umfasst, das eine Metalloberfläche (4) und optional eine Oxidoberfläche (5) freilegt,
b. Selektives Anbringen einer selbstaufbauenden Einzelschicht (10), auf der freigelegten Metalloberfläche (4) und/ oder Oxidoberfläche (5),
c. Züchten eines Metalls (9) auf der selbstaufbauenden Einzelschicht (10) und auf der freigelegten Metalloberfläche (4), falls darauf keine selbstaufbauende Einzelschicht (10) vorhanden ist, um das zumindest eine Durchgangsloch zu füllen und dadurch zumindest eine Metallstruktur (9) zu bilden,
d. Ersetzen der ersten Opferschicht (2) durch eine dielektrische Ersatzschicht (11), welche eine dielektrische Konstante von höchstens 3,9 aufweist.

2. Verfahren nach Anspruch 1, wobei:
- das zumindest eine Durchgangsloch, das eine Metalloberfläche (4) und optional eine Oxidoberfläche (5) freilegt, zumindest eine Durchkontaktierung ist, welche eine Metalloberfläche (4) freilegt,
- Schritt b zum selektiven Anbringen einer selbstaufbauenden Einzelschicht (10) auf der freigelegten Metalloberfläche (4) und/ oder Oxidoberfläche (5) darin besteht, eine selbstaufbauende Einzelschicht (10) selektiv auf der freigelegten Metalloberfläche (4) anzubringen, und
- Schritt c zum Züchten eines Metalls (9) auf der selbstaufbauenden Einzelschicht (10) und auf der freigelegten Metalloberfläche (4), falls darauf keine selbstaufbauende Einzelschicht (10) vorhanden ist, um das zumindest eine Durchgangsloch zu füllen und dadurch zumindest eine Metallstruktur (9) zu bilden, darin besteht, ein Metall (9) auf der selbstaufbauenden Einzelschicht (10) zu züchten, um die zumindest eine Durchkontaktierung zu füllen, wodurch zumindest eine Metallsäule (9) gebildet wird.

3. Verfahren nach Anspruch 2, wobei die Struktur darüber hinaus eine erste dielektrische Schicht (1) umfasst, welche die erste Opferschicht (2) überlagert, und eine zweite Opferschicht (2'), welche die erste dielektrische Schicht (1) überlagert, wobei die zumindest eine Durchkontaktierung die erste Opferschicht (2), die erste dielektrische Schicht (1) und die zweite Opferschicht (2') durchschneidet, wobei das Verfahren darüber hinaus nach Schritt a und vor Schritt b Folgendes umfasst:
i. Abdecken der Seitenwände der Durchkontaktierung mit einer Passivierungsschicht (14),
ii. Füllen der zumindest einen Durchkontaktierung mit einem dielektrischen Material (7), sodass die obere Fläche des dielektrischen Materials (7) und die obere Fläche der zweiten Opferschicht (2') komplanar sind,
iii. Überlagern des dielektrischen Materials (7) und der zweiten Opferschicht (2') mit einer Hartmaske (12),
iv. Überlagern der Hartmaske (12) mit einer dritten Opferschicht (2"),
v. Überlagern der dritten Opferschicht (2") mit einer zweiten dielektrischen Schicht (1'),
vi. Ätzen eines oder mehrerer Gräben durch die zweite dielektrische Schicht (1'), die dritte Opferschicht (2") und die Hartmaske (12) hindurch, sodass zumindest einer der besagten Gräben mit zumindest einer Durchkontaktierung fluchtet, wodurch das dielektrische Material (7) und ein Teil der zweiten Opferschicht (2') freigelegt wird,
vii. Entfernen des dielektrischen Materials (7) wodurch die Metalloberfläche (4) freigelegt wird.

4. Verfahren nach Anspruch 3, wobei in Schritt c das Züchten des Metalls (9) die zumindest eine Durchkontaktierung bis auf unter die erste dielektrische Schicht (1) füllt und wobei das Verfahren darüber hinaus nach Schritt c und vor Schritt d Folgendes umfasst:
i. Entfernen der freigelegten Passivierungsschicht (14) und Entfernen der zweiten Opferschicht (2') aus dem Inneren der Gräben, um einen Teil der ersten dielektrischen Schicht (1) freizulegen,
ii. Entfernen der zweiten dielektrischen Schicht (1'),
iii. Selektives Anbringen einer selbstaufbauenden Einzelschicht (10) auf der ersten dielektrischen Schicht (1),
iv. Züchten eines Metalls (9) auf der selbstaufbauenden Einzelschicht (10) und auf dem Metall (9), um das Füllen der zumindest einen Durchkontaktierung zu vervollständigen und um den zumindest einen Graben zu füllen,

5. Verfahren nach Anspruch 2, darüber hinaus nach Schritt a und vor Schritt b Folgendes umfassend:
i. Füllen der zumindest einen Durchkontaktierung mit einem dielektrischen Material (7), sodass die obere Fläche des dielektrischen Materials (7) und die obere Fläche der ersten Opferschicht (2) komplanar sind, wodurch zumindest eine dielektrische (7) Säule gebildet wird,
ii. Ätzen eines Teils der ersten Opferschicht (2), bis ein oberer Abschnitt der zumindest einen dielektrischen (7) Säule aus der ersten Opferschicht (2) hervorsteht,
iii. Überlagern von dem, was von der ersten Opferschicht (2) übrig ist und des oberen Abschnitts der zumindest einen dielektrischen (7) Säule mit einer konformen dielektrischen Schicht (8),
iv. Bereitstellen einer zweiten Opferschicht (2') auf der besagten konformen dielektrischen Schicht (8),
v. Bereitstellen einer dielektrischen Schicht (1) auf der besagten zweiten Opferschicht (2'),
vi. Bilden zumindest eines Grabens in der besagten dielektrischen Schicht (1), der besagten zweiten Opferschicht (2') und der besagten konformen dielektrischen Schicht (8), dergestalt, um die obere Fläche der zumindest einen dielektrischen (7) Säule freizulegen,
vii. Entfernen der dielektrischen (7) Säule, wodurch die Metalloberfläche (4) freigelegt wird.

6. Verfahren nach Anspruch 2, wobei die Struktur die erste Opferschicht (2), eine erste dielektrische Schicht (1) und eine zweite Opferschicht (2') umfasst, wobei die zumindest eine Durchkontaktierung jede dieser Schichten durchschneidet, wobei die zweite Opferschicht (2') darüber hinaus zumindest einen Graben umfasst, der mit einer oder mehreren der besagten zumindest einen Durchkontaktierung fluchtet, wobei in Schritt c das Züchten des Metalls (9) die zumindest eine Durchkontaktierung nur bis unterhalb der ersten dielektrischen Schicht (1) füllt, und wobei das Verfahren darüber hinaus nach Schritt c und vor Schritt d Folgendes umfasst:
i. Entfernen der zweiten Opferschicht (2') aus dem Inneren der Gräben, um einen Teil der ersten dielektrischen Schicht (1) freizulegen,
ii. Selektives Anbringen einer selbstaufbauenden Einzelschicht (10) auf der freigelegten ersten dielektrischen Schicht (1),
iii. Züchten eines Metalls (9) auf der selbstaufbauenden Einzelschicht (10) und auf dem Metall (9), um das Füllen der zumindest einen Durchkontaktierung zu vervollständigen und um den zumindest einen Graben zu füllen.

7. Verfahren nach Anspruch 5, wobei in Schritt c das Züchten des Metalls (9) die zumindest eine Durchkontaktierung bis auf unter die konforme dielektrische Schicht (8) füllt und wobei das Verfahren darüber hinaus nach Schritt c und vor Schritt d Folgendes umfasst:
i. Entfernen der zweiten Opferschicht (2') aus dem Inneren der Gräben, um die darunterliegende konforme dielektrische Schicht (8) freizulegen,
ii. Selektives Anbringen einer weiteren selbstaufbauenden Einzelschicht (10') auf der freigelegten konformen dielektrischen Schicht (8),
iii. Züchten eines Metalls (9) auf der weiteren selbstaufbauenden Einzelschicht (10') und auf dem Metall (9), um den zumindest einen Graben zu füllen.

8. Verfahren nach Anspruch 2, wobei Schritt c das Züchten eines Metalls (9) auf der selbstaufbauenden Einzelschicht (10) umfasst, um die zumindest eine Durchkontaktierung zu füllen und um die obere Fläche der ersten Opferschicht (2) abzudecken, gefolgt von einer chemischen mechanischen Planarisierung, bis das gesamte Metall (9), das auf der oberen Fläche der ersten Opferschicht (2) vorhanden ist, entfernt worden ist.

9. Verfahren nach Anspruch 2, darüber hinaus nach Schritt c und vor Schritt d Folgendes umfassend:
i. Ätzen eines Teils der ersten Opferschicht (2) bis ein oberer Abschnitt einer jeden der zumindest einen metallischen (9) Säule aus der ersten Opferschicht (2) hervorsteht,
ii. Überlagern von dem, was von der ersten Opferschicht (2) übrig ist und des oberen Abschnitts der zumindest einen metallischen (9) Säule mit einer konformen dielektrischen Schicht (8),
iii. Bereitstellen einer zweiten Opferschicht (2') auf der besagten konformen dielektrischen Schicht (8),
iv. Bilden zumindest eines Grabens in der besagten zweiten Opferschicht (2') derart, um die obere Fläche einer jeden der zumindest einen metallischen (9) Säule und einen Abschnitt der konformen dielektrischen Schicht (8) freizulegen,
v. Selektives Anbringen einer selbstaufbauenden Einzelschicht (10) auf der freigelegten konformen dielektrischen Schicht (8),
vi. Züchten eines Metalls (9) auf der selbstaufbauenden Einzelschicht (10) und auf der freigelegten oberen Fläche der zumindest einen metallischen (9) Säule, um den zumindest einen Graben zu füllen.

10. Verfahren nach Anspruch 9, wobei Schritt iv die folgenden Schritte umfasst:
- Überlagern der zweiten Opferschicht (2') mit einer dielektrischen Schicht (1),
- Überlagern der dielektrischen Schicht (1) mit einem gemusterten Fotolack (6), zumindest eine Öffnung umfassend, die zumindest einem Graben entspricht, der zu bilden ist,
- Ätzen der dielektrischen Schicht (1) und der zweiten Opferschicht (2') durch die besagte zumindest eine Öffnung hindurch, um die konforme dielektrische Schicht (8) freizulegen, welche die zumindest eine metallische (9) Säule abdeckt,
- Entfernen der dielektrischen Schicht (1) und der freigelegten konformen dielektrischen Schicht (8) welche die zumindest eine metallische (9) Säule abdeckt,
- Ätzen der zweiten Opferschicht (2'), bis die konforme dielektrische Schicht (8) in dem zumindest einen Graben freigelegt ist.

11. Verfahren nach Anspruch 9 oder 10, wobei Schritt vi das Züchten eines Metalls (9) auf der selbstaufbauenden Einzelschicht (10) und auf der freigelegten oberen Fläche der zumindest einen metallischen (9) Säule umfasst, um den zumindest einen Graben zu füllen und um die obere Fläche der zweiten Opferschicht (2') freizulegen, gefolgt von einer chemischen mechanischen Planarisierung, bis das gesamte Metall (9), das auf der oberen Fläche der zweiten Opferschicht (2') vorhanden ist, entfernt worden ist.

12. Verfahren nach Anspruch 1, wobei:
- das zumindest eine Durchgangsloch, das eine Metalloberfläche (4) und optional eine Oxidoberfläche (5) freilegt, zumindest ein Graben ist, der eine Metalloberfläche (4) und eine Oxidoberfläche (5) freilegt,
- Schritt b zum selektiven Anbringen einer selbstaufbauenden Einzelschicht (10) auf der freigelegten Metalloberfläche (4) und/ oder Oxidoberfläche (5) darin besteht, eine selbstaufbauende Einzelschicht (10) selektiv auf der Oxidoberfläche (5) anzubringen,
- Schritt c zum Züchten eines Metalls (9) auf der selbstaufbauenden Einzelschicht (10) und auf der freigelegten Metalloberfläche (4), falls keine selbstaufbauende Einzelschicht (10) darauf vorhanden ist, um das zumindest eine Durchgangsloch zu füllen, und somit zumindest eine Metallstruktur (9) zu bilden, darin besteht, ein Metall (9) auf der selbstaufbauenden Einzelschicht (10) und auf der Metalloberfläche (4) zu züchten, um den zumindest einen Graben zu füllen.

13. Verfahren nach irgendeinem der vorhergehenden Schritte, wobei Schritt a die folgenden Schritte umfasst:
i. Bereitstellen einer Oxidschicht (5), welche eine Dicke aufweist, die durch zumindest ein Metallelement (4) durchkreuzt wird,
ii. Überlagern der Oxidschicht (5) mit einer Ätzblockschicht (3),
iii. Überlagern der Ätzblockschicht (3) mit der besagten ersten Opferschicht (2),
iv. Überlagern der ersten Opferschicht (2) mit einer ersten dielektrischen Schicht (1),
v. Bereitstellen eines gemusterten Fotolacks (6) oben auf der ersten dielektrischen Schicht (1), zumindest eine Öffnung umfassend, die dem zumindest einen Durchgangsloch entspricht, das zu bilden ist,
vi. Ätzen der ersten dielektrischen Schicht (1) und der ersten Opferschicht (2), um das zumindest eine Durchgangsloch zu bilden, wodurch ein Abschnitt der Ätzblockschicht (3) freigelegt wird,
vii. Entfernen des Fotolacks (6),
viii. Entfernen der ersten dielektrischen Schicht (1) und Ätzen des Abschnitts der Ätzblockschicht (3), um die obere Metalloberfläche (4) des Metallelements (4) freizulegen.

14. Verfahren nach Anspruch 6, wobei Schritt a die folgenden Schritte umfasst:
i. Bereitstellen einer ersten Oxidschicht (5), welche eine Dicke aufweist, die durch zumindest ein Metallelement (4) durchkreuzt wird,
ii. Überlagern der ersten Oxidschicht (5) mit einer Ätzblockschicht (3),
iii. Überlagern der Ätzblockschicht (3) mit der besagten ersten Opferschicht (2),
iv. Überlagern der ersten Opferschicht (2) mit einer ersten dielektrischen Schicht (1),
v. Überlagern der ersten dielektrischen Schicht (1) mit einer zweiten Opferschicht (2'),
vi. Überlagern der zweiten Opferschicht (2') mit einer zweiten dielektrischen Schicht (1'),
vii. Überlagern der zweiten Opferschicht (2') mit einer Hartmaske (12),
viii. Überlagern der Hartmaske (12) mit dem gemusterten Fotolack (6), zumindest eine Grabenöffnung umfassend, die zumindest einem Graben entspricht, der zu bilden ist,
ix. Ätzen der Hartmaske (12) durch die besagte Grabenöffnung hindurch, um einen Teil der zweiten dielektrischen Schicht (1') freizulegen,
x. Entfernen des gemusterten Fotolacks (6),
xi. Überlagern der Hartmaske (12) und der freigelegten Teile der zweiten dielektrischen Schicht (1') mit einem weiteren gemusterten Fotolack (6'), zumindest eine Durchkontaktierungsöffnung umfassend, die zumindest einer Durchkontaktierung entspricht, die direkt über dem besagten zumindest einen Graben zu bilden ist,
xii. Ätzen der zweiten dielektrischen Schicht (1'), der zweiten Opferschicht (2'), der ersten dielektrischen Schicht (1) und der ersten Opferschicht (2) durch die besagte zumindest eine Durchkontaktierungsöffnung hindurch, um einen Teil der Ätzblockschicht (3) freizulegen,
xiii. Entfernen des weiteren gemusterten Fotolacks (6'),
xiv. Ätzen der freigelegten Ätzblockschicht und der zweiten dielektrischen Schicht (1') durch die Hartmaske hindurch, um die obere Metallfläche (4) des Metallelements (4) aufzudecken, und um zu stoppen, bevor die erste dielektrische Schicht (1) erreicht wird, und xv. Entfernen der Hartmaske (12) und der zweiten dielektrischen Schicht (1').

15. Verfahren nach irgendeinem der vorhergehenden Ansprüche, wobei Schritt d die folgenden Schritte umfasst:
i. Entfernen aller Opferschichten (2, 2', 2"), der konformen dielektrischen Schicht (8), falls vorhanden, und der ersten dielektrischen Schicht (1), falls vorhanden, wodurch das zumindest eine Metallelement (9) freigelegt wird,
ii. Umgeben des Metallelements (9) mit einer dielektrischen Ersatzschicht (11), welche eine dielektrische Konstante von höchstens 3,9 aufweist,
iii. Durchführen einer chemischen mechanischen Planarisierung der dielektrischen Ersatzschicht (11), welche eine dielektrische Konstante von höchstens 3,9 aufweist, bis die obere Fläche des Metallelements (9) freigelegt ist.

16. Verfahren nach Anspruch 15, wobei die Metallstruktur (9) eine Kupferstruktur ist und wobei die freigelegte Metallstruktur (9) vor dem Schritt ii selektiv mit einer Sperrschicht (13) beschichtet wird.

## Revendications

1. Procédé pour fabriquer un dispositif à semi-conducteur, comprenant :
a. la fourniture d'une structure comprenant une première couche sacrificielle (2) comprenant au moins un trou traversant exposant une surface de métal (4) et éventuellement une surface d'oxyde (5),
b. l'application d'une monocouche auto-assemblée (10) sélectivement sur la surface de métal (4) exposée et/ou sur la surface d'oxyde (5),
c. la croissance d'un métal (9) sur la monocouche auto-assemblée (10) et sur la surface de métal (4) exposée si aucune monocouche auto-assemblée (10) n'est présente sur celles-ci, de manière à remplir l'au moins un trou traversant, formant ainsi au moins une structure de métal (9),
d. le remplacement de la première couche sacrificielle (2) par une couche diélectrique de remplacement (11) ayant une constante diélectrique d'au maximum 3,9.

2. Procédé selon la revendication 1, dans lequel :
- l'au moins un trou traversant exposant une surface de métal (4) et éventuellement une surface d'oxyde (5) est au moins un trou d'interconnexion exposant une surface de métal (4),
- l'étape b d'application d'une monocouche auto-assemblée (10) sélectivement sur la surface de métal (4) exposée et/ou sur la surface d'oxyde (5) consiste à appliquer une monocouche auto-assemblée (10) sélectivement sur la surface de métal (4) exposée, et
- l'étape c de croissance d'un métal (9) sur la monocouche auto-assemblée (10) et sur la surface de métal (4) exposée si aucune monocouche auto-assemblée (10) n'est présente sur celles-ci, de manière à remplir l'au moins un trou traversant, formant ainsi au moins une structure de métal (9), consiste à faire croître un métal (9) sur la monocouche auto-assemblée (10) de manière à remplir l'au moins un trou d'interconnexion, formant ainsi au moins un montant en métal (9).

3. Procédé selon la revendication 2, dans lequel la structure comprend en outre une première couche diélectrique (1) recouvrant la première couche sacrificielle (2), et une deuxième couche sacrificielle (2') recouvrant la première couche diélectrique (1), dans lequel l'au moins un trou d'interconnexion coupe à travers la première couche sacrificielle (2), la première couche diélectrique (1) et la deuxième couche sacrificielle (2'), le procédé comprenant en outre, après l'étape a et avant l'étape b :
i. le revêtement des parois latérales du trou d'interconnexion avec une couche de passivation (14),
ii. le remplissage de l'au moins un trou d'interconnexion avec un matériau diélectrique (7) de telle sorte que la surface supérieure du matériau diélectrique (7) et la surface supérieure de la deuxième couche sacrificielle (2') sont coplanaires,
iii. le fait de recouvrir le matériau diélectrique (7) et la deuxième couche sacrificielle (2') avec un masque dur (12),
iv. le fait de recouvrir le masque dur (12) avec une troisième couche sacrificielle (2"),
v. le fait de recouvrir la troisième couche sacrificielle (2") avec une deuxième couche diélectrique (1'),
vi. la gravure d'une ou de plusieurs tranchées à travers la deuxième couche diélectrique (1'), la troisième couche sacrificielle (2") et le masque dur (12) de telle sorte qu'au moins l'une desdites tranchées est alignée sur au moins un trou d'interconnexion, exposant ainsi le matériau diélectrique (7) et une partie de la deuxième couche sacrificielle (2'),
vii. le retrait du matériau diélectrique (7), exposant ainsi la surface de métal (4).

4. Procédé selon la revendication 3, dans lequel à l'étape c la croissance du métal (9) remplit l'au moins un trou d'interconnexion uniquement jusqu'au-dessous de la première couche de passivation (1) et dans lequel le procédé comprend en outre après l'étape c et avant l'étape d :
i. le retrait de la couche de passivation exposée (14) et le retrait de la deuxième couche sacrificielle (2') de l'intérieur des tranchées de manière à exposer une partie de la première couche diélectrique (1),
ii. le retrait de la deuxième couche diélectrique (1'),
iii. l'application d'une monocouche auto-assemblée (10) sélectivement sur la première couche diélectrique (1),
iv. la croissance d'un métal (9) sur la monocouche auto-assemblée (10) et sur le métal (9) de manière à terminer le remplissage de l'au moins un trou d'interconnexion et de manière à remplir l'au moins une tranchée.

5. Procédé selon la revendication 2, comprenant en outre après l'étape a et avant l'étape b :
i. le remplissage de l'au moins un trou d'interconnexion avec un matériau diélectrique (7) de telle sorte que la surface supérieure du matériau diélectrique (7) et la surface supérieure de la première couche sacrificielle (2) sont coplanaires, formant ainsi au moins un montant diélectrique (7),
ii. la gravure d'une partie de la première couche sacrificielle (2) jusqu'à ce qu'une portion supérieure de l'au moins un montant diélectrique (7) repose à l'extérieur de la première couche sacrificielle (2),
iii. le fait de recouvrir ce qu'il reste de la première couche sacrificielle (2) et la portion supérieure de l'au moins un montant diélectrique (7) avec une couche diélectrique conforme (8),
iv. la fourniture d'une deuxième couche sacrificielle (2') sur ladite couche diélectrique conforme (8),
v. la fourniture d'une couche diélectrique (1) sur ladite deuxième couche sacrificielle (2'),
vi. la formation d'au moins une tranchée dans ladite couche diélectrique (1), ladite deuxième couche sacrificielle (2') et ladite couche diélectrique conforme (8) d'une manière à exposer la surface supérieure de l'au moins un montant diélectrique (7),
vii. le retrait du montant diélectrique (7), exposant ainsi la surface de métal (4).

6. Procédé selon la revendication 2, dans lequel la structure comprend la première couche sacrificielle (2), une première couche diélectrique (1) et une deuxième couche sacrificielle (2'), dans lequel l'au moins un trou d'interconnexion coupe à travers chacune de ces couches, la deuxième couche sacrificielle (2') comprenant en outre au moins une tranchée alignée sur un ou plusieurs dudit au moins un trou d'interconnexion, dans lequel à l'étape c la croissance du métal (9) remplit l'au moins un trou d'interconnexion uniquement jusqu'au-dessous de la première couche diélectrique (1) et dans lequel le procédé comprend en outre après l'étape c et avant l'étape d :
i. le retrait de la deuxième couche sacrificielle (2') de l'intérieur des tranchées de manière à exposer une partie de la première couche diélectrique (1),
ii. l'application d'une monocouche auto-assemblée (10) sélectivement sur la première couche diélectrique (1) exposée,
iii. la croissance d'un métal (9) sur la monocouche auto-assemblée (10) et sur le métal (9) de manière à terminer le remplissage de l'au moins un trou d'interconnexion et de manière à remplir l'au moins une tranchée.

7. Procédé selon la revendication 5, dans lequel à l'étape c la croissance du métal (9) remplit l'au moins un trou d'interconnexion uniquement jusqu'au-dessous de la couche diélectrique conforme (8) et dans lequel le procédé comprend en outre après l'étape c et avant l'étape d :
i. le retrait de la deuxième couche sacrificielle (2') de l'intérieur des tranchées de manière à exposer la couche diélectrique conforme sous-jacente (8),
ii. l'application d'une autre monocouche auto-assemblée (10') sélectivement sur la couche diélectrique (8) exposée,
iii. la croissance d'un métal (9) sur l'autre monocouche auto-assemblée (10') et sur le métal (9) de manière à remplir l'au moins une tranchée.

8. Procédé selon la revendication 2, dans lequel l'étape c comprend la croissance d'un métal (9) sur la monocouche auto-assemblée (10) de manière à remplir l'au moins un trou d'interconnexion et à revêtir la surface supérieure de la première couche sacrificielle (2), suivie d'une planarisation mécanique chimique jusqu'à ce que tout le métal (9) présent sur la surface supérieure de la première couche sacrificielle (2) ait été retiré.

9. Procédé selon la revendication 2, comprenant en outre après l'étape c et avant l'étape d :
i. la gravure d'une partie de la première couche sacrificielle (2) jusqu'à ce qu'une portion supérieure de chacun de l'au moins un montant en métal (9) repose à l'extérieur de la première couche sacrificielle (2),
ii. le fait de recouvrir ce qu'il reste de la première couche sacrificielle (2) et la portion supérieure de l'au moins un montant en métal (9) avec une couche diélectrique conforme (8),
iii. la fourniture d'une deuxième couche sacrificielle (2') sur ladite couche diélectrique conforme (8),
iv. la formation d'au moins une tranchée dans ladite deuxième couche sacrificielle (2') de manière à exposer la surface supérieure de chacun de l'au moins un montant en métal (9) et une portion de la couche diélectrique conforme (8),
v. l'application d'une monocouche auto-assemblée (10) sélectivement sur la couche diélectrique conforme (8) exposée,
vi. la croissance d'un métal (9) sur la monocouche auto-assemblée (10) et sur la surface supérieure exposée de l'au moins un montant en métal (9), de manière à remplir l'au moins une tranchée.

10. Procédé selon la revendication 9, dans lequel l'étape iv comprend les étapes consistant à :
- le fait de recouvrir la deuxième couche sacrificielle (2') avec une couche diélectrique (1),
- le fait de recouvrir la couche diélectrique (1) avec une résine photosensible modelée (6) comprenant au moins une ouverture correspondant à au moins une tranchée à former,
- la gravure de la couche diélectrique (1) et de la deuxième couche sacrificielle (2') à travers ladite au moins une ouverture de manière à exposer la couche diélectrique conforme (8) revêtant l'au moins un montant en métal (9),
- le retrait de la couche diélectrique (1) et de la couche diélectrique conforme (8) exposée revêtant l'au moins un montant en métal (9), et
- la gravure de la deuxième couche sacrificielle (2') jusqu'à ce que la couche diélectrique conforme (8) soit exposée dans l'au moins une tranchée.

11. Procédé selon la revendication 9 ou 10 dans lequel l'étape vi comprend la croissance d'un métal (9) sur la monocouche auto-assemblée (10) et sur la surface supérieure exposée de l'au moins un montant en métal (9), de manière à remplir l'au moins une tranchée et à revêtir la surface supérieure de la deuxième couche sacrificielle (2'), suivie d'une planarisation mécanique chimique jusqu'à ce que tout le métal (9) présent sur la surface supérieure de la deuxième couche sacrificielle (2') ait été retiré.

12. Procédé selon la revendication 1, dans lequel :
- l'au moins un trou traversant exposant une surface de métal et éventuellement une surface d'oxyde (5) est au moins une tranchée exposant une surface de métal (4) et une surface d'oxyde (5),
- l'étape b d'application d'une monocouche auto-assemblée (10) sélectivement sur la surface de métal (4) exposée et/ou sur la surface d'oxyde (5) consiste à appliquer une monocouche auto-assemblée (10) sélectivement sur la surface d'oxyde (5) exposée,
- l'étape c de croissance d'un métal (9) sur la monocouche auto-assemblée (10) et sur la surface de métal (4) exposée si aucune monocouche auto-assemblée (10) n'est présente sur celles-ci de manière à remplir l'au moins un trou traversant, formant ainsi au moins une structure de métal (9) consiste à faire croître un métal (9) sur la monocouche auto-assemblée (10) et sur la surface de métal (4) de manière à remplir l'au moins une tranchée.

13. Procédé selon l'une quelconque des revendications précédentes, dans lequel l'étape a comprend les étapes consistant à :
i. fournir une couche d'oxyde (5) ayant une épaisseur croisée par au moins un élément de métal (4),
ii. recouvrir la couche d'oxyde (5) avec une couche de blocage de gravure (3),
iii. recouvrir la couche de blocage de gravure (3) avec ladite première couche sacrificielle (2),
iv. recouvrir la première couche sacrificielle (2) avec une première couche diélectrique (1),
v. fournir une résine photosensible modelée (6) sur la première couche diélectrique (1), comprenant au moins une ouverture correspondant à l'au moins un trou traversant à former,
vi. graver la première couche diélectrique (1) et de la première couche sacrificielle (2) de manière à former l'au moins un trou traversant, exposant ainsi une portion de la couche de blocage de gravure (3),
vii. retirer la résine photosensible (6),
viii. retirer la première couche diélectrique (1) et graver la portion de la couche de blocage de gravure (3) de manière à exposer la surface de métal supérieure (4) de l'élément de métal (4).

14. Procédé selon la revendication 6, dans lequel l'étape a comprend les étapes consistant à :
i. fournir une première couche d'oxyde (5) ayant une épaisseur croisée par au moins un élément de métal (4),
ii. recouvrir la première couche d'oxyde (5) avec une couche de blocage de gravure (3),
iii. recouvrir la couche de blocage de gravure (3) avec ladite première couche sacrificielle (2),
iv. recouvrir la première couche sacrificielle (2) avec une première couche diélectrique (1),
v. recouvrir la première couche diélectrique (1) avec une deuxième couche sacrificielle (2'),
vi. recouvrir la deuxième couche sacrificielle (2') avec une deuxième couche diélectrique (1'),
vii. recouvrir la deuxième couche sacrificielle (2') avec un masque dur (12),
viii. recouvrir le masque dur (12) avec la résine photosensible modelée (6) comprenant au moins une ouverture de tranchée correspondant à au moins une tranchée à former,
ix. graver le masque dur (12) à travers ladite ouverture de tranchée de manière à exposer une partie de la deuxième couche diélectrique (1'),
x. retirer la résine photosensible modelée (6),
xi. recouvrir le masque dur (12) et les parties exposées de la deuxième couche diélectrique (1') avec une autre résine photosensible modelée (6') comprenant au moins une ouverture de trou d'interconnexion correspondant à au moins un trou d'interconnexion à former directement au-dessus de ladite au moins une tranchée,
xii. graver la deuxième couche diélectrique (1'), la deuxième couche sacrificielle (2'), la première couche diélectrique (1) et la première couche sacrificielle (2) à travers ladite au moins une ouverture de trou d'interconnexion de manière à exposer une partie de la couche de blocage de gravure (3),
xiii. retirer l'autre résine photosensible modelée (6'),
xiv. graver la couche de blocage de gravure exposée et la deuxième couche diélectrique (1') à travers le masque dur de manière à exposer la surface de métal (4) supérieure de l'élément de métal (4) et de manière à s'arrêter avant d'atteindre la première couche diélectrique (1), et
xv. retirer le masque dur (12) et la deuxième couche diélectrique (1').

15. Procédé selon l'une quelconque des revendications précédentes, dans lequel l'étape d comprend les étapes consistant à :
i. retirer toutes les couches sacrificielles (2, 2', 2"), la couche diélectrique conforme (8) si présente et la première couche diélectrique (1) si présente, exposant ainsi l'au moins un élément de métal (9),
ii. entourer l'élément de métal (9) avec une couche diélectrique de remplacement (11) ayant une constante diélectrique d'au maximum 3,9,
iii. effectuer une planarisation mécanique chimique de la couche diélectrique de remplacement (11) ayant une constante diélectrique d'au maximum 3,9 jusqu'à ce que la surface supérieure de l'élément de métal (9) soit exposée.

16. Procédé selon la revendication 15, dans lequel la structure de métal (9) est une structure de cuivre et dans lequel avant l'étape ii, la structure de métal (9) exposée est sélectivement revêtue d'une couche barrière (13).
